# EUROPEAN PATENT SPECIFICATION

(11) **EP 4 138 536 B1**
(45) Date of publication and mention of the grant of the patent: **06.05.2026**
(21) Application number: 22190859.3
(22) Date of filing: 17.08.2022
(51) Int. Cl.: H10K 59/18, H10K 59/38, H10K 59/35

(54) **TILED DISPLAY DEVICE**
MOSAIKANZEIGEVORRICHTUNG
DISPOSITIF D'AFFICHAGE EN MOSAÏQUE

(30) Priority: 18.08.2021 KR 20210109077
(43) Date of publication of application: 22.02.2023
(73) Proprietor: Samsung Display Co., Ltd., Yongin-si, Gyeonggi-do 17113 (KR)
(72) Inventor: HUH, Jong Moo, 17113 Yongin-si (KR); JEONG, Jin Wook, 17113 Yongin-si (KR); PARK, Sun, 17113 Yongin-si (KR); EOM, Ki Chang, 17113 Yongin-si (KR); LEE, Gwang Geun, 17113 Yongin-si (KR)
(74) Representative: Marks & Clerk LLP

(56) References cited:
- EP-A1- 3 786 693
- EP-A2- 1 244 146

## Description

### 1. Technical Field

Various embodiments of the disclosure relate to a tiled display device.

### 2. Description of the Related Art

Recently, as interest in information display is increasing, research and development of display devices are continuously made. EP 3 786 693 A1 discloses a display device characterized by comprising: a first unit, the first unit comprises: a first substrate; and a light blocking structure having a plurality of first openings and disposed on the first substrate; and a plurality of second units, each comprises: a second substrate; and a plurality of light emitting diodes disposed on the second substrate and corresponding to a portion of the plurality of first openings. EP 1 244 146 A2 discloses a method of making a tiled emissive display having at least two aligned tiles, comprising the steps of: a) finishing at least one edge of each tile and aligning the finished edges of such tiles; b) forming a monolithic structure including aligned tiles, each such aligned tile having a substrate, TFT circuits, drive circuits and bottom pixel electrodes for providing electrical signals to pixels in the corresponding tile; c) coating the aligned tiles with material that produces light when activated by an electric field; and d) forming at least one top pixel electrode over the coated material so that the coated material produces light when activated by an electric field from the electrode.

### SUMMARY

According to an aspect, there is provided a tiled display device according to independent claims 1 and 15. Details of embodiments are provided in the dependent claims.

Various embodiments of the disclosure are directed to a tiled display device, in which external visibility is improved and process productivity is improved.

The disclosure is not limited to the above-described objects, and other objects that are not mentioned will be clearly understood by those skilled in the art from the following description.

An embodiment of the disclosure may provide a tiled display device including a first panel including a first display element layer; a second panel including a second display element layer; and a shared layer including a color conversion part. The shared layer includes a first portion and a second portion. The first portion overlaps with the first panel in a plan view. The second portion overlaps with the second panel in a plan view. The color conversion part changes a wavelength of light provided from the first panel and the second panel.

In an embodiment, the first panel and the second panel may form a lower panel of the tiled display device, and the shared layer may form an upper panel of the tiled display device.

In an embodiment, the first panel and the second panel may be disposed on a same layer, and the first panel and the second panel may be spaced apart from each other, and a bonding area is disposed between the first panel and the second panel.

In an embodiment, the bonding area may overlap the shared layer in a plan view.

In an embodiment, the color conversion part may include a first color part providing light of a first color, a second color part providing light of a second color, and a third color part providing light of a third color. The first color part, the second color part, and the third color part may overlap the first panel and the second panel in a plan view.

In an embodiment, the tiled display device may further include a first sub-pixel area emitting the light of the first color and overlapping the first color part in a plan view; a second sub-pixel area emitting the light of the second color and overlapping the second color part in a plan view; and a third sub-pixel area emitting the light of the third color and overlapping the third color part in a plan view.

In an embodiment, the shared layer may further include a first color filter overlapping the first sub-pixel area in a plan view, a second color filter overlapping the second sub-pixel area in a plan view, and a third color filter overlapping third sub-pixel area in a plan view.

In an embodiment, wherein the first display element layer includes a first light emitting element, and the second display element layer includes a second light emitting element. The tiled display device may further include an emission area in which the first light emitting element and the second light emitting element are disposed, and the emission area may be defined by components included in the first display element layer and the second display element layer.

In an embodiment, each of the first display element layer and the second display element layer may include a bank protruding in a display direction of the tiled display device, and the bank may have a shape enclosing the emission area.

In an embodiment, the emission area may include a first emission area overlapping the first sub-pixel area in a plan view, a second emission area overlapping the second sub-pixel area in a plan view, and a third emission area overlapping third sub-pixel area in a plan view.

In an embodiment, the first color part may be disposed to be misaligned from the first emission area in a plan view, the second color part may be disposed to be misaligned from the second emission area in a plan view, and the third color part may be disposed to be misaligned from the third emission area in a plan view.

In an embodiment, at least part of the first color part may overlap the first emission area in a plan view, and other part of the first color part may not overlap the first emission area in a plan view.

In an embodiment, the first panel and the first portion of the shared layer may form a first display device, the second panel and the second portion of the shared layer may form a second display device, in the first display device and the second display device, the first sub-pixel area, the second sub-pixel area, and the third sub-pixel area may be adjacent to each other and may be spaced apart from each other by a first separation distance, a first adjacent sub-pixel area of the first display device and a second adjacent sub-pixel area of the second display device may be spaced apart from each other by a second separation distance, the first adjacent sub-pixel area may be an area closest to the second display device, among the first sub-pixel area, the second sub-pixel area, and the third sub-pixel area disposed in the first display device, the second adjacent sub-pixel area may be an area closest to the first display device, among the first sub-pixel area, the second sub-pixel area, and the third sub-pixel area disposed in the second display device, and the first separation distance may be equal to the second separation distance.

In an embodiment, in the first and second display devices, the first emission area, the second emission area, and the third emission area may be adjacent to each other and may be spaced apart from each other by a first emission separation distance, a first adjacent emission area of the first display device and a second adjacent emission area of the second display device may be spaced apart from each other by a second emission separation distance, the first adjacent emission area may be an area closest to the second display device, among the first emission area, the second emission area, and the third emission area disposed in the first display device, the second adjacent emission area may be an area closest to the first display device, among the first emission area, the second emission area, and the third emission area disposed in the second display device, and the first emission separation distance may be different from the second emission separation distance.

In an embodiment, the second emission separation distance may be greater than the second separation distance.

In an embodiment, when viewed from an outside, the light of the first color may be observed in the first sub-pixel area, the light of the second color may be observed in the second sub-pixel area, and the light of the third color may be observed in the third sub-pixel area.

In an embodiment, the first panel and the second panel may be disposed on a same layer, the first panel and the second panel may be spaced apart from each other, a bonding area may be disposed between the first panel and the second panel, and a thickness of the bonding area may be smaller than the second separation distance.

In an embodiment, the first color part may include a first quantum dot converting the light of the third color into the light of the first color, and the second color part may include a second quantum dot converting the light of the third color into the light of the second color.

In an embodiment, the first display element layer may include a first light emitting element, and the second display element layer may include a second light emitting element. In an embodiment each of the first light emitting element and the second light emitting element may emit the light of the third color.

In an embodiment, a color of light provided by the first adjacent sub-pixel area and a color of light provided by the second adjacent sub-pixel area may be different from each other.

In an embodiment, the first light emitting element and the second light emitting element may be an organic light emitting diode or a light emitting diode having a size in a range of a nanoscale to a microscale.

An embodiment of the disclosure provides a tiled display device including a first display device including a first substrate, a first display element layer disposed on the first substrate, and a first upper layer disposed on the first display element layer; and a second display device including a second substrate, a second display element layer disposed on the second substrate, and a second upper layer disposed on the second display element layer. The first upper layer and the second upper layer are integral with each other, and each of the first upper layer and the second upper layer include a first color part including a first quantum dot and a second color part including a second quantum dot.

An embodiment of the disclosure provides a tiled display device including a first sub-pixel area emitting light of a first color, a second sub-pixel area emitting light of a second color, and a third sub-pixel area emitting light of a third color, the tiled display device including a first panel including a first substrate, and a first display element layer disposed on the first substrate and including a first light emitting element emitting the light of the third color; a second panel including a second substrate, and a second display element layer disposed on the second substrate and including a second light emitting element configured to emit the light of the third color; and a shared layer including a first area overlapping the first panel in a plan view, and a second area overlapping the second panel in a plan view. The first sub-pixel area, the second sub-pixel area, and the third sub-pixel area are defined by the shared layer.

The disclosure is not limited to the above-described embodiments, and other embodiments that are not mentioned will be clearly understood by those skilled in the art from the specification and the accompanying drawings.

At least some of the above and other features of the invention are set out in the claims.

### BRIEF DESCRIPTION OF THE DRAWINGS

An additional appreciation according to the embodiments of the disclosure will become more apparent by describing in detail the embodiments thereof with reference to the accompanying drawings, wherein:
FIG. 1 is a schematic plan view illustrating a tiled display device in accordance with an embodiment of the disclosure.
FIG. 2 is a schematic perspective view illustrating a tiled display device in accordance with an embodiment of the disclosure.
FIG. 3 is a schematic block diagram illustrating a tiled display device in accordance with an embodiment of the disclosure.
FIG. 4 is a schematic diagram of an equivalent circuit illustrating a pixel circuit included in a pixel in accordance with an embodiment of the disclosure.
FIG. 5 is a schematic plan view illustrating a pixel in accordance with a first embodiment of the disclosure.
FIG. 6 is a schematic cross-sectional view taken along line II-II' of FIG. 5.
FIG. 7 is a schematic cross-sectional view illustrating a pixel in accordance with a second embodiment of the disclosure.
FIG. 8 is a schematic cross-sectional view illustrating a pixel including a shared layer, and is a cross-sectional view taken along line I - I' of FIG. 1.
FIGS. 9 to 11 are schematic enlarged views illustrating area EA1 of FIG. 1.

### DETAILED DESCRIPTION OF THE EMBODIMENTS

The embodiments described herein are by way of example only, the disclosure is not limited to the embodiments. It should be interpreted that various changes and modifications may be made in the disclosure without departing from the scope of the invention.

The terms "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

It will be understood that the terms "contact," "connected to," and "coupled to" may include a physical and/or electrical contact, connection, or coupling, and vice versa.

The phrase "at least one of" is intended to include the meaning of "at least one selected from the group of" for the purpose of its meaning and interpretation. For example, "at least one of A and B" may be understood to mean "A, B, or A and B."

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

The accompanying drawings are for the purpose of easily describing particular embodiments, and may be exaggerated as necessary to aid in understanding of the disclosure. The disclosure is not limited to embodiments shown in the drawings.

When it is determined that the detailed description of the known art related to the disclosure may obscure the gist of the disclosure, the detailed description will be omitted.

Various embodiments of the disclosure relate to a tiled display device. Hereinafter, a tiled display device in accordance with an embodiment will be described with reference to the accompanying drawings.

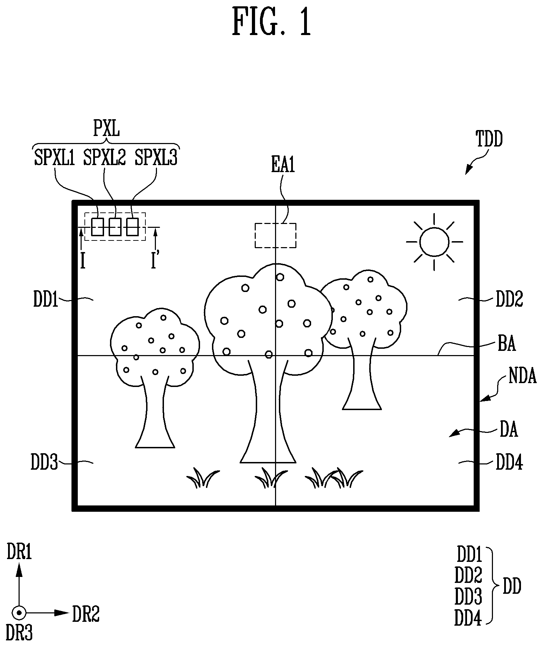

FIG. 1 is a schematic plan view illustrating a tiled display device in accordance with an embodiment.

A tiled display device TDD may be configured to provide visual information to a user. The tiled display device TDD may provide (or emit) light in a display direction (e.g., a third direction DR3) of the tiled display device TDD.

The tiled display device TDD may be provided by combining display devices DD. According to an embodiment, the tiled display device TDD may display a large screen by combining the display devices DD, and thus may be applied to a field requiring a wide display surface such as the surface of an outdoor billboard.

The display devices DD included in the tiled display device TDD may include first to fourth display devices DD1 to DD4. According to an embodiment, the tiled display device TDD may include four display devices DD. However, the number of display devices DD forming (or configuring) the tiled display device TDD is not limited to a specific example. Hereinafter, for the convenience of description, an embodiment including four display devices DD1, DD2, DD3, and DD4 will be described.

The tiled display device TDD may include a pixel PXL, a display area DA, a non-display area NDA, and a bonding area BA.

Light may be output in the display area DA. The pixel PXL may be disposed in the display area DA. The display area DA may be formed on a top surface of the tiled display device TDD. However, the disclosure is not limited thereto. The display area DA may be formed on a side surface and/or a rear surface of the tiled display device TDD. Herein, an embodiment in which the display area DA is formed on a top surface of the tiled display device TDD will be described.

The pixel PXL may be disposed in the display area DA. The pixel PXL may include a first sub-pixel SPXL1, a second sub-pixel SPXL2, and a third sub-pixel SPXL3. The first to third sub-pixels SPXL1, SPXL2, and SPXL3 may output light of different colors, respectively. For example, the light of a first color may be output from the first sub-pixel SPXL1, the light of a second color may be output from the second sub-pixel SPXL2, and the light of a third color may be output from the third sub-pixel SPXL3.

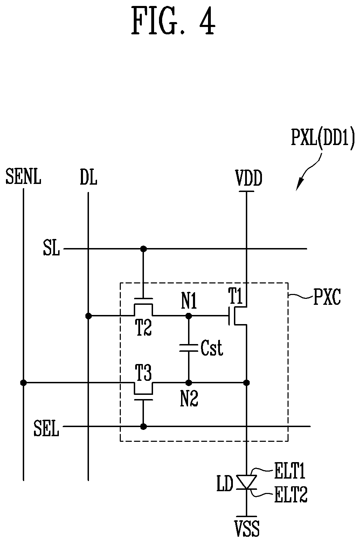

Each of the first to third sub-pixels SPXL1, SPXL2, and SPXL3 may include a light emitting element LD (see FIG. 4). The light emitting element LD is configured to emit light.

Light may not be output in the non-display area NDA. The non-display area NDA is an area other than the display area DA and the bonding area BA, and the pixel PXL may not be disposed in the non-display area NDA.

According to an embodiment, the non-display area NDA may have a shape that encloses a portion of the display area DA. However, the disclosure is not limited to the above example. For instance, the non-display area NDA may be selectively disposed inside the display area DA.

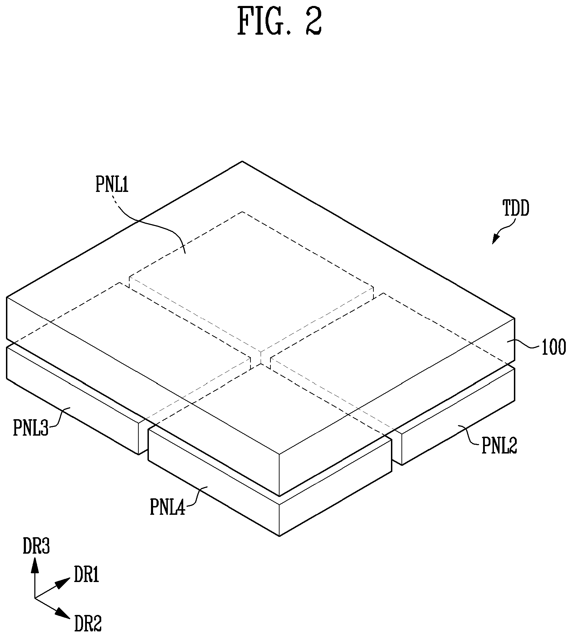

The bonding area BA may mean an area between first to fourth panels PNL1 to PNL4 (see FIG. 2) respectively included in the display devices DD1, DD2, DD3 and DD4 included in the tiled display device TDD. According to an embodiment, at least a portion of the bonding area BA may be disposed between the first panel PNL1 and the second panel PNL2. For instance, the bonding area BA may include a first bonding area disposed between the first panel PNL1 and the second panel PNL2, a second bonding area disposed between the first panel PNL1 and the third panel PNL3, a third bonding area disposed between the second panel PNL2 and the fourth panel PNL4, and a fourth bonding area disposed between the third panel PNL3 and the fourth panel PNL4.

According to an embodiment, the bonding area BA may overlap a shared layer 100 (see FIG. 2) in a plan view. For instance, at least a portion of the shared layer 100 may be provided in the bonding area BA.

According to an embodiment, the tiled display device TDD may include the shared layer 100 disposed across the first to fourth display devices DD1 to DD4. The shared layer 100 may overlap the first to fourth panels PNL1 to PNL4 in a plan view. The shared layer 100 may overlap the bonding area BA in a plan view.

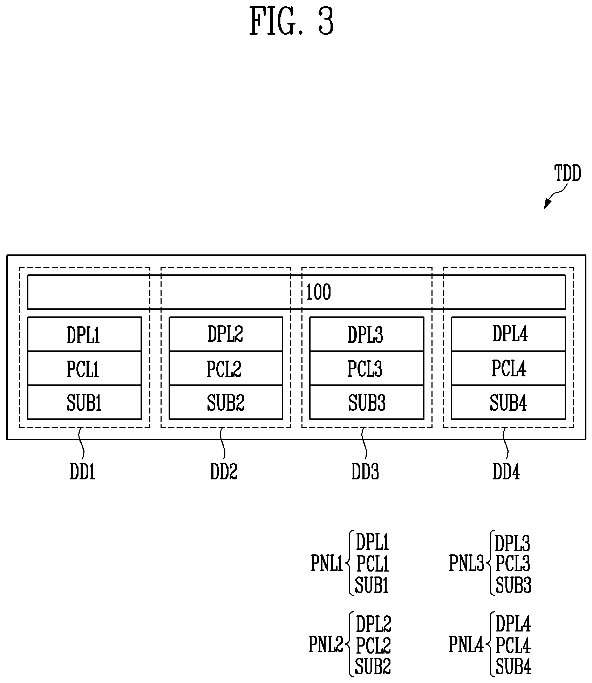

Hereinafter, the description of a tiled display device TDD in accordance with an embodiment will be focused on the shared layer 100 with reference to FIGS. 2 and 3.

FIG. 2 is a schematic perspective view schematically illustrating a tiled display device in accordance with an embodiment. FIG. 3 is a block diagram illustrating a tiled display device in accordance with an embodiment.

Referring to FIGS. 2 and 3, the tiled display device TDD may include a first panel PNL1, a second panel PNL2, a third panel PNL3, a fourth panel PNL4, and a shared layer 100. Here, the first to fourth panels PNL1 to PNL4 may be provided as a lower structure of the tiled display device TDD, while the shared layer 100 may be provided as an upper structure.

The first display device DD1 may include the first panel PNL1 and at least a portion of the shared layer 100. For instance, the first display device DD1 may include the first panel PNL1 and a first shared layer (or a first upper layer). The first shared layer is a portion of the shared layer 100 and may overlap the first panel PNL1. The first panel PNL1 may overlap a first area (e.g., a first portion) of the shared layer 100 in a plan view.

The second display device DD2 may include the second panel PNL2 and at least a portion of the shared layer 100. For instance, the second display device DD2 may include the second panel PNL2 and a second shared layer (or a second upper layer). The second shared layer is a portion of the shared layer 100 and may overlap the second panel PNL2. The second panel PNL2 may overlap the second area (e.g., a second portion) of the shared layer 100 in a plan view.

The third display device DD3 may include the third panel PNL3 and at least a portion of the shared layer 100. For instance, the third display device DD3 may include the third panel PNL3 and a third shared layer (or a third upper layer). The third shared layer is a portion of the shared layer 100 and may overlap the third panel PNL3. The third panel PNL3 may overlap the third area (e.g., a third portion) of the shared layer 100 in a plan view.

The fourth display device DD4 may include the fourth panel PNL4 and at least a portion of the shared layer 100. For instance, the fourth display device DD4 may include the fourth panel PNL4 and a fourth shared layer (or a fourth upper layer). The fourth shared layer is a portion of the shared layer 100 and may overlap the fourth panel PNL4. The fourth panel PNL4 may overlap the fourth area (e.g., a fourth portion) of the shared layer 100 in a plan view.

According to an embodiment, the first to fourth shared layers may be integrated with each other.

The first panel PNL1 may be connected to at least a portion of the shared layer 100. For instance, an upper surface of the first panel PNL1 and a lower surface of the shared layer 100 may be connected by an adhesive member. The adhesive member may include an adhesive material, but the disclosure is not limited to a specific example. Likewise, each of the second to fourth panels PNL2 to PNL4 may be connected to a portion of the shared layer 100.

The first panel PNL1 is a part of the first display device DD1 and may refer to a lower panel of the first display device DD1. Similarly, the second to fourth panels PNL2 to PNL4 are parts of the second to fourth display devices DD2 to DD4, respectively, and may refer to lower panels of the second to fourth display devices DD2 to DD4.

According to an embodiment, the first to fourth panels PNL1 to PNL4 may be spaced apart from each other. For example, as described above, the first panel PNL1 may be spaced apart from the second panel PNL2, the third panel PNL3, and the fourth panel PNL4 with the bonding area BA interposed therebetween. According to an embodiment, adjacent panels (e.g., the first panel PNL1 and the second panel PNL2) may be connected in the bonding area BA.

According to an embodiment, the first panel PNL1, the second panel PNL2, the third panel PNL3, and the fourth panel PNL4 may be placed on a same layer.

The first panel PNL1 may include a first substrate SUB1, a first pixel circuit part PCL1, and a first display element part DPL1. The first substrate SUB1, the first pixel circuit part PCL1, and the first display element part DPL1 may be successively stacked in the thickness direction (e.g., the third direction DR3) of the first substrate SUB1. Similarly, the second to fourth panels PNL2 to PNL4 may include second to fourth substrates SUB2 to SUB4, second to fourth pixel circuit parts PCL2 to PCL4, and second to fourth display element parts DPL2 to DPL4, respectively, which are successively stacked in the third direction DR3.

The first to fourth panels PNL1 to PNL4 may emit light. For instance, the first to fourth display element parts DPL1 to DPL4 included in the first to fourth panels PNL1 to PNL4, respectively, may include light emitting elements LD configured to emit light.

For example, the first display element part DPL1 may include a first light emitting element, the second display element part DPL2 may include a second light emitting element, the third display element part DPL3 may include a third light emitting element, and the fourth display element part DPL4 may include a fourth light emitting element.

According to an embodiment, "display element part" may be referred to as a "display element layer". For example, the first display element part DPL1 may be a first display element layer, the second display element part DPL2 may be a second display element layer, the third display element part DPL3 may be a third display element layer, and the fourth display element part DPL4 may be a fourth display element layer.

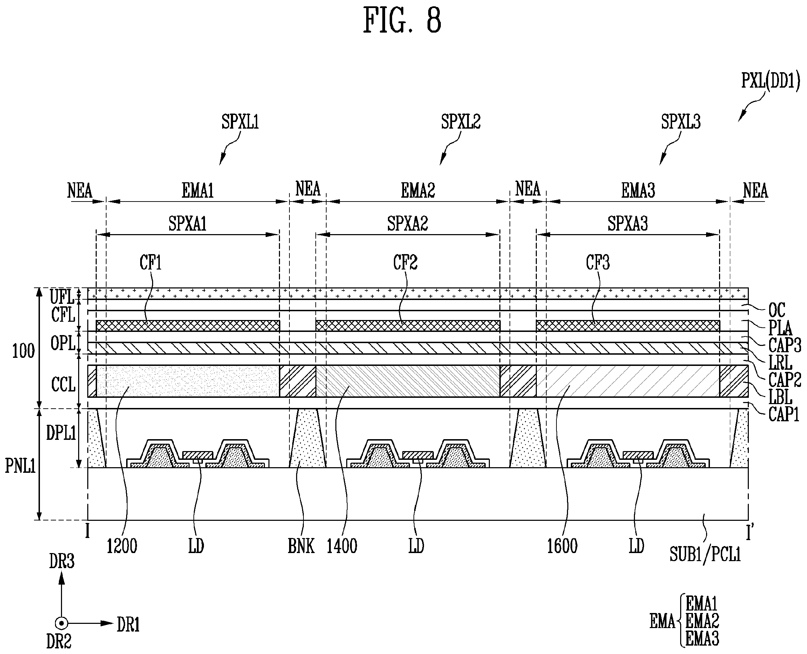

The first panel PNL1 may overlap the shared layer 100 in a plan view. According to an embodiment, the first panel PNL1 may overlap a color conversion part CCL (see FIG. 8) and/or a color filter part CFL (FIG. 8) included in the shared layer 100 when viewed in a plan view. Similarly, each of the second to fourth panels PNL2 to PNL4 may overlap the shared layer 100 in a plan view. This will be described below in detail with reference to FIG. 8.

The first panel PNL1 and the second to fourth panels PNL2 to PNL4 may be formed by different processes. For instance, the first panel PNL1 may be manufactured by a separate process and be coupled (or connected) with the second to fourth panels PNL2 to PNL4.

The first display device DD1 may include the first panel PNL1 and at least a portion of the shared layer 100. For instance, the first display device DD1 may include the first panel PNL1 and a first shared layer. The first shared layer is a portion of the shared layer 100 and may refer to a portion overlapping the first panel PNL1.

Hereinafter, display devices DD included in the tiled display device TDD in accordance with an embodiment will be described in detail. However, for the convenience of description, the first display device DD1 among the display devices DD will be described. According to an embodiment, the technical features described with reference to the first display device DD1 may be applied to the second to fourth display devices DD2 to DD4.

According to an embodiment, the structure illustrated in FIGS. 4 to 7 may represent the first panel PNL1 of the first display device DD1.

First, a pixel circuit PXC of the pixel PXL included in the first display device DD1 according to an embodiment will be described with reference to FIG. 4. FIG. 4 is a schematic diagram illustrating an equivalent pixel circuit included in a pixel in accordance with an embodiment.

Referring to FIG. 4, the pixel PXL may include a light emitting element LD and a pixel circuit PXC.

The light emitting element LD may be electrically connected between a first power line VDD and a second power line VSS. A first end (e.g., a P-type semiconductor) of the light emitting element LD may be electrically connected to the first power line VDD via a first electrode ELT1 and the pixel circuit PXC, while a second end (e.g., an N-type semiconductor) of the light emitting element LD may be electrically connected to the second power line VSS via a second electrode ELT2.

In an embodiment, the light emitting element LD may emit light having a luminance corresponding to driving current supplied thereto through the pixel circuit PXC.

In an embodiment, two or more of the light emitting elements LD may be provided in the pixel PXL and may be electrically connected to each other through various connecting structures between the first power line VDD and the second power line VSS. For instance, the light emitting elements LD may be electrically connected to each other only in parallel or only in series. As another example, the light emitting elements LD may be electrically connected in a serial-parallel mixed structure.

The first and second power lines VDD and VSS may have different potentials to allow the light emitting elements LD to emit light. The first and second power lines VDD and VSS may have a potential difference to allow light to be emitted during the light emission period of the pixel PXL. For example, the first power line VDD may be set to a potential higher than that of the second power line VSS.

The pixel circuit PXC may electrically connect the first power line VDD to the light emitting element LD. The pixel circuit PXC may include a first transistor T1, a second transistor T2, a third transistor T3, and a storage capacitor Cst.

According to an embodiment, a first electrode of the first transistor T1 may be electrically connected to the first power line VDD, while a second electrode thereof may be electrically connected to a first electrode (e.g., an anode electrode) of the light emitting element LD. A gate electrode of the first transistor T1 may be electrically connected to a first node N1. The first transistor T1 may control a current flowing through the light emitting element LD in response to a voltage applied thereto through the first node N1.

According to an embodiment, a first electrode of the second transistor T2 may be electrically connected to a data line DL, while a second electrode thereof may be electrically connected to the first node N1. A gate electrode of the second transistor T2 may be electrically connected to a scan line SL. In case that a scan signal is supplied from the scan line SL, the second transistor T2 may be turned on. In this case, a data signal provided from the data line DL may be transmitted to the first node N1.

According to an embodiment, a first electrode of the third transistor T3 may be electrically connected to a sensing line SENL, while a second electrode thereof may be electrically connected to a second node N2. A gate electrode of the third transistor T3 may be electrically connected to a sensing signal line SEL. In case that the third transistor T3 is turned on in response to a sensing signal provided from the sensing signal line SEL, a reference voltage may be provided to the second node N2 through the sensing line SENL.

According to an embodiment, the reference voltage may serve to set or initialize the voltage of the electrode (e.g., a source electrode of the first transistor T1) of the first transistor T1 electrically connected to the light emitting element LD to a constant value. For example, the reference voltage may be set to be less than or equal to the voltage of the second power line VSS.

According to an embodiment, in case that the third transistor T3 is turned on in response to a sensing signal provided from the sensing signal line SEL, the sensing current may be transmitted to the sensing line SENL.

In an embodiment, the sensing current may be used to calculate changes in mobility and threshold voltage of the first transistor T1.

The storage capacitor Cst may be electrically connected between the first node N1 (or the gate electrode of the first transistor T1) and the second node N2 (or the second electrode of the first transistor T1). The storage capacitor Cst may store information about a difference in voltage between the first node N1 and the second node N2.

The structure of the pixel circuit PXC is not limited to the structure illustrated in FIG. 4, and various types of structures may be implemented. FIG. 4 illustrates the first to third transistors T1 to T3 as an N-type transistor. However, the disclosure is not limited thereto. The first to third transistors T1 to T3 may be formed of the P-type transistor according to an embodiment.

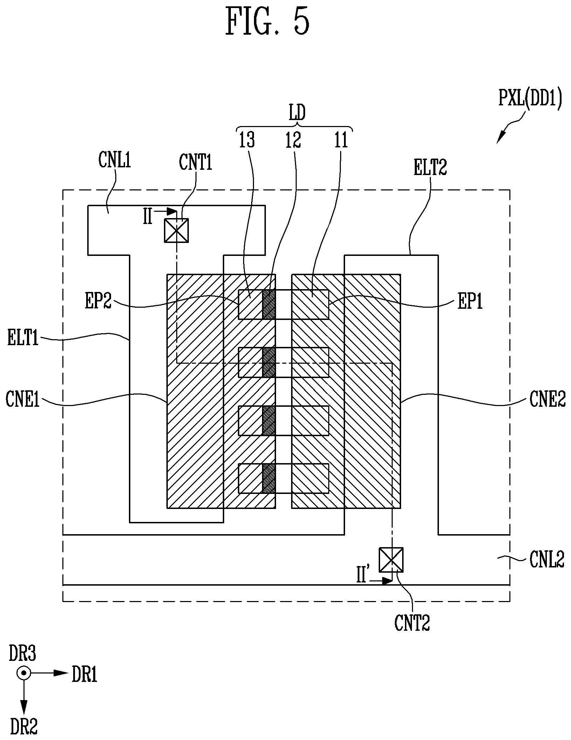

Hereinafter, the structure of the pixel PXL according to an embodiment will be described with reference to FIGS. 5 to 7. Contents that may overlap the above-described contents will be briefly described or omitted.

In an embodiment, the pixel PXL may include the light emitting element LD. For example, the light emitting element LD may be a light emitting diode or an organic light emitting diode (OLED) having in a size range of a nanoscale to a microscale.

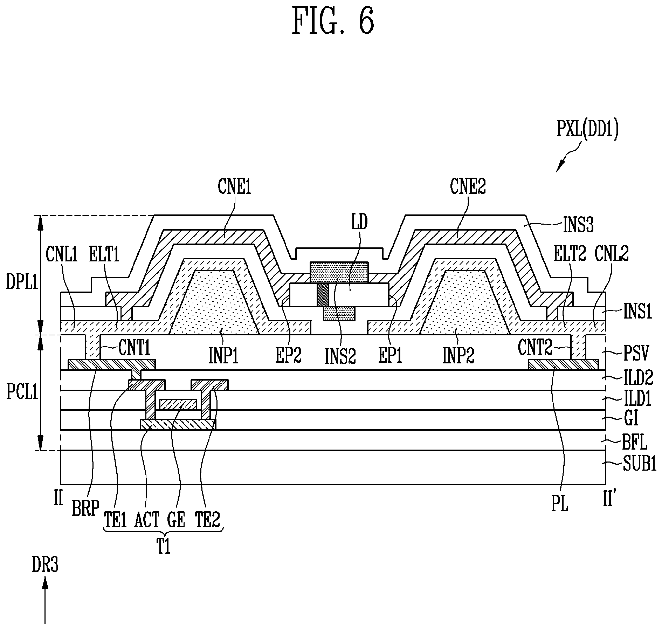

First, an embodiment where the light emitting element LD is a light emitting diode having a size in a range of a nanoscale to a microscale, as the pixel PXL according to the first embodiment, will be described with reference to FIGS. 5 and 6.

FIG. 5 is a schematic plan view illustrating a pixel in accordance with a first embodiment of the disclosure. The pixel PXL shown in FIG. 5 may be at least one of first to third sub-pixels SPXL1, SPXL2, and SPXL3.

Referring to FIG. 5, the pixel PXL may include a first electrode ELT1, a second electrode ELT2, a first connection electrode CNL1, a second connection electrode CNL2, a first contact part CNT1, a second contact part CNT2, a light emitting element LD, a first contact electrode CNE1, and a second contact electrode CNE2.

Light emitting elements LD may be provided and arranged. For example, the light emitting elements LD may be arranged in a parallel structure in the second direction DR2. However, the arrangement structure of the light emitting elements LD is not limited thereto.

In an embodiment, the light emitting element LD may be provided in the shape of a rod extending in a direction. The light emitting element LD may have a first end EP1 and a second end EP2. A first semiconductor layer 11 may be adjacent to the first end EP1 of the light emitting element LD. A second semiconductor layer 13 may be adjacent to the second end EP2 of the light emitting element LD.

In an embodiment, the light emitting element LD may be a light emitting element manufactured in a columnar shape by an etching method or the like. In this specification, the term "columnar shape" embraces a rod-like shape and a bar-like shape such as a cylindrical shape and a prismatic shape extending in a longitudinal direction (e.g., to have an aspect ratio greater than 1), and the cross-sectional shape thereof is not limited to a particular shape. For example, the length of the light emitting element LD may be greater than a diameter thereof (or a width of the cross-section thereof). However, the shape of the light emitting element LD is not limited to the above-mentioned examples.

In an embodiment, the light emitting element LD may have a size corresponding to a range of a nanometer scale to a micrometer scale.

In an embodiment, the light emitting element LD may include a first semiconductor layer 11, a second semiconductor layer 13, and an active layer 12 interposed between the first and second semiconductor layers 11 and 13.

The first semiconductor layer 11 may be a first conductive semiconductor layer. For example, the first semiconductor layer 11 may include an N-type semiconductor layer. For instance, the first semiconductor layer 11 may include an N-type semiconductor layer which includes at least one semiconductor material of InAlGaN, GaN, AlGaN, InGaN, AIN, and InN and is doped with a first conductive dopant such as Si, Ge, or Sn. However, the material forming the first semiconductor layer 11 is not limited thereto.

The active layer 12 may be disposed on the first semiconductor layer 11 and have a single-quantum well structure or a multi-quantum well structure. For instance, in case that the active layer 12 has the multiple quantum well structure, the active layer 12 may be formed by periodically and repeatedly stacking a barrier layer, a strain reinforcing layer, and a well layer as one unit. The strain reinforcing layer may have a lattice constant smaller than that of the barrier layer, and thus may further reinforce strain applied to the well layer, for example, compression strain. However, the structure of the active layer 12 is not limited to the above-described embodiment.

In an embodiment, the active layer 12 may emit light having a wavelength of about 400 nm to about 900 nm. For example, the active layer 12 may include a material such as AlGaN or InAlGaN. However, the material is not limited to the above-described example.

The second semiconductor layer 13 may be disposed on the active layer 12 and include a semiconductor layer having a type different from that of the first semiconductor layer 11. For example, the second semiconductor layer 13 may include a P-type semiconductor layer. For instance, the second semiconductor layer 13 may include a P-type semiconductor layer which includes at least one semiconductor material of InAlGaN, GaN, AlGaN, InGaN, AIN, and InN and is doped with a second conductive dopant such as Mg. However, the material forming the second semiconductor layer 13 is not limited thereto, and the second semiconductor layer 13 may be formed of various other materials.

If a voltage equal to or greater than a threshold voltage is applied to the opposite ends of the light emitting element LD, the light emitting element LD emits light by recombination of electron-hole pairs in the active layer 12. Since light emission of the light emitting element LD can be controlled based on the foregoing principle, the light emitting element LD may be used as a light source of various light emitting devices.

In an embodiment, the light emitting element LD may further include an element insulating layer. The element insulating layer may be disposed on the outer surface of the light emitting element LD to stabilize electrical connection.

For example, the element insulating layer may include an inorganic material. For instance, the element insulating layer may be formed in a single-layer or multi-layer structure including at least one insulating material selected from at least one of silicon oxide (SiOₓ), silicon nitride (SiNₓ), silicon oxynitride (SiOₓN_{y}), aluminum oxide (AlOₓ), and titanium oxide (TiOₓ).

The structure of the light emitting element LD is not limited to the above-described example, and may further include an additional component. For example, the light emitting element LD may further include a phosphor layer, an active layer, an electrode layer, etc.

The light emitting element LD may be disposed between electrodes configured to function as alignment electrodes. For instance, the light emitting element LD may be disposed between the first electrode ELT1 and the second electrode ELT2 in a plan view. The light emitting element LD may be disposed on the first electrode ELT1 and the second electrode ELT2. At least a portion of the light emitting element LD may be disposed between the first electrode ELT1 and the second electrode ELT2 in a plan view.

The light emitting element LD may be electrically connected to the first electrode ELT1 through the first contact electrode CNE1.

According to an embodiment, the second end EP2 of the light emitting element LD may be electrically connected to the first contact electrode CNE1. Thus, the second semiconductor layer 13 of the light emitting element LD may be electrically connected to the first electrode ELT1 and the first contact electrode CNE1.

The light emitting element LD may be electrically connected to the second electrode ELT2 through the second contact electrode CNE2.

According to an embodiment, the first end EP1 of the light emitting element LD may be electrically connected to the second contact electrode CNE2. Thus, the first semiconductor layer 11 of the light emitting element LD may be electrically connected to the second electrode ELT2 and the second contact electrode CNE2.

The first electrode ELT1 may extend in the second direction DR2. The first electrode ELT1 may be spaced apart from the second electrode ELT2 in the first direction DR1. The first electrode ELT1 may be electrically connected to the first connection electrode CNL1. The first direction DR1 may intersect (or may not be parallel to) the second direction DR2.

The first connection electrode CNL1 may be electrically connected to a bridge pattern BRP (see FIG. 6) included in the first pixel circuit part PCL1 through the first contact part CNT1. The first connection electrode CNL1 and the first electrode ELT1 may be disposed on a same layer and be formed integrally with (or integral with) each other.

The second electrode ELT2 may extend in the second direction DR2. The second electrode ELT2 may be spaced apart from the first electrode ELT1 in the first direction DR1. The second electrode ELT2 may be electrically connected to the second connection electrode CNL2.

The second connection electrode CNL2 may be electrically connected to a power line PL (see FIG. 6) included in the first pixel circuit part PCL1 through the second contact part CNT2. The second connection electrode CNL2 and the second electrode ELT2 may be disposed on a same layer and be integral with each other.

The first contact electrode CNE1 may be disposed on the first electrode ELT1 to be electrically connected to the first electrode ELT1. The first contact electrode CNE1 may electrically connect the first electrode ELT1 to the light emitting element LD.

The second contact electrode CNE2 may be disposed on the second electrode ELT2 to be electrically connected to the second electrode ELT2. The second contact electrode CNE2 may electrically connect the second electrode ELT2 to the light emitting element LD.

FIG. 6 is a schematic cross-sectional view illustrating a pixel PXL in accordance with an embodiment. FIG. 6 is a schematic cross-sectional view taken along line II-II' of FIG. 5. Hereinafter, for the convenience of description, the first transistor T1 will be mainly described among the above-described first to third transistors T1 to T3.

Referring to FIG. 6, the pixel PXL may include a first substrate SUB1, a first pixel circuit part PCL1, and a first display element part DPL1.

The first substrate SUB1 may provide an area in which the first pixel circuit part PCL1 and the first display element part DPL1 are disposed. The first substrate SUB1 may form a base member of the pixel PXL. The first substrate SUB1 may be a rigid or flexible substrate or film, but the disclosure is not limited to a specific example.

The first pixel circuit part PCL1 may be disposed on the first substrate SUB1. The first pixel circuit part PCL1 may include a buffer layer BFL, a first transistor T1, a gate insulating layer GI, a first interlayer insulating layer ILD1, a second interlayer insulating layer ILD2, a bridge pattern BRP, a power line PL, a passivation layer PSV, a first contact part CNT1, a second contact part CNT2.

The buffer layer BFL may be disposed on the first substrate SUB1. The buffer layer BFL may prevent impurities from being diffused from the outside. The buffer layer BFL may include at least one of inorganic materials such as silicon nitride (SiNₓ), silicon oxide (SiOₓ), silicon oxynitride (SiOₓN_{y}), and aluminum oxide (AlOₓ).

The first transistor T1 may be a thin-film transistor. According to an embodiment, the first transistor T1 may be a driving transistor.

The first transistor T1 may be electrically connected to the light emitting element LD. The first transistor T1 may be electrically connected to the bridge pattern BRP.

The first transistor T1 includes an active layer ACT, a first transistor electrode TE1, a second transistor electrode TE2, and a gate electrode GAT.

The active layer ACT may refer to a semiconductor layer. The semiconductor layer ACT may be disposed on the buffer layer BFL. The active layer ACT may include at least one of polysilicon, low-temperature polycrystalline silicon (LTPS), amorphous silicon, and oxide semiconductor.

The active layer ACT may include a first contact area that contacts the first transistor electrode TE1 and a second contact area that contacts the second transistor electrode TE2. Each of the first and second contact areas may be a semiconductor pattern doped with impurities. An area between the first contact area and the second contact area may be a channel area. The channel area may be an intrinsic semiconductor pattern undoped with impurities.

The gate electrode GE may be disposed on the gate insulating layer GI. A position of the gate electrode GE may correspond to a position of the channel area of the active layer ACT. For example, the gate electrode GE may be disposed on the channel area of the active layer ACT with the gate insulating layer GI being interposed therebetween.

The gate insulating layer GI may be disposed on the active layer ACT. The gate insulating layer GI may include an inorganic material. For example, the gate insulating layer GI may include at least one of silicon nitride (SiNₓ), silicon oxide (SiOₓ), silicon oxynitride (SiOₓN_{y}), and aluminum oxide (AlOₓ).

The first interlayer insulating layer ILD1 may be located on the gate electrode GE. Similar to the gate insulating layer GI, the first interlayer insulating layer ILD1 may include at least one of silicon nitride (SiNₓ), silicon oxide (SiOₓ), silicon oxynitride (SiOₓN_{y}), and aluminum oxide (AlOₓ).

The first transistor electrode TE1 and the second transistor electrode TE2 may be positioned on the first interlayer insulating layer ILD1. The first transistor electrode TE1 may pass through the gate insulting layer GI and the first interlayer insulating layer ILD1 to contact the first contact area of the active layer ACT, while the second transistor electrode TE2 may pass through the gate insulting layer GI and the first interlayer insulating layer ILD1 to contact the second contact area of the active layer ACT. For example, the first transistor electrode TE1 may be a drain electrode and the second transistor electrode TE2 may be a source electrode. However, the disclosure is not limited thereto.

The second interlayer insulating layer ILD2 may be positioned on the first transistor electrode TE1 and the second transistor electrode TE2. Similar to the first interlayer insulating layer ILD1 and the gate insulating layer GI, the second interlayer insulating layer ILD2 may include an inorganic material. The inorganic material may include the materials forming the first interlayer insulating layer ILD1 and the gate insulating layer GI, for instance, at least one of silicon nitride (SiNₓ), silicon oxide (SiOₓ), silicon oxynitride (SiOₓN_{y}), and aluminum oxide (AlOₓ).

The bridge pattern BRP may be disposed on the second interlayer insulating layer ILD2. The bridge pattern BRP may be electrically connected to the first transistor electrode TE1 through a contact hole passing through the second interlayer insulating layer ILD2. The bridge pattern BRP may be electrically connected to the first electrode ELT1 through the first contact part CNT1 formed in the passivation layer PSV.

The power line PL may be disposed on the second interlayer insulating layer ILD2. The power line PL may be electrically connected to the second electrode ELT2 through the second contact part CNT2 formed in the passivation layer PSV.

The passivation layer PSV may be located on the second interlayer insulating layer ILD2. The passivation layer PSV may cover the bridge pattern BRP and the power line PL. The passivation layer PSV may be provided in the form of an organic insulating layer, an inorganic insulating layer, or the organic insulating layer disposed on the inorganic insulating layer, but the disclosure is not limited thereto. According to an embodiment, the passivation layer PSV may include a first contact part CNT1 that is electrically connected to an area of the bridge pattern BRP, and a second contact part CNT2 that is electrically connected to an area of the power line PL.

The first display element part DPL1 may be disposed on the first pixel circuit part PCL1. The first display element part DPL1 may include a first insulating pattern INP1, a second insulating pattern INP2, a first electrode ELT1, a second electrode ELT2, a first insulating layer INS1, a light emitting element LD, a second insulating layer INS2, a first contact electrode CNE1, a second contact electrode CNE2, and a third insulating layer INS3.

The first insulating pattern INP1 and the second insulating pattern INP2 may be disposed on the passivation layer PSV. Each of the first insulating pattern INP1 and the second insulating pattern INP2 may have a shape protruding in the thickness direction of the first substrate SUB1.

The first electrode ELT1 and the second electrode ELT2 may be disposed on the passivation layer PSV. According to an embodiment, at least a portion of the first electrode ELT1 may be disposed on the first insulating pattern INP1, and at least a portion of the second electrode ELT2 may be disposed on the second insulating pattern INP2, to serve as reflective partition walls.

The first electrode ELT1 may be electrically connected to the bridge pattern BRP through the first contact part CNT1. The second electrode ELT2 may be electrically connected to the power line PL through the second contact part CNT2.

The first electrode ELT1 may be electrically connected to the light emitting element LD. The first electrode ELT1 may be electrically connected to the first contact electrode CNE1 through the contract hole formed in the first insulating layer INS1. The first electrode ELT1 may apply an anode signal to the light emitting element LD.

The second electrode ELT2 may be electrically connected to the light emitting element LD. The second electrode ELT2 may be electrically connected to the second contact electrode CNE2 through the contract hole formed in the first insulating layer INS1. The second electrode ELT2 may apply a cathode signal (e.g., a ground signal) to the light emitting element LD.

Each of the first and second electrodes ELT1 and ELT2 may include a conductive material. For instance, each of the first and second electrodes ELT1 and ELT2 may include metal such as silver (Ag), magnesium (Mg), aluminum (Al), platinum (Pt), palladium (Pd), gold (Au), nickel (Ni), neodymium (Nd), iridium (Ir), chromium (Cr), titanium (Ti), and alloys thereof. However, the disclosure is not limited to the above example.

The first insulating layer INS1 may be disposed on the passivation layer PSV. The first insulating layer INS1 may cover the first electrode ELT1 and the second electrode ELT2. The first insulating layer INS1 may stabilize the connection between electrode components and reduce external influences. The first insulating layer INS1 may include at least one of silicon nitride (SiNₓ), silicon oxide (SiOₓ), silicon oxynitride (SiOₓN_{y}), and aluminum oxide (AlOₓ).

The light emitting element LD may be disposed on the first insulating layer INS1. The light emitting element LD may emit light in response to electrical signals provided from the first contact electrode CNE1 and the second contact electrode CNE2.

The second insulating layer INS2 may be disposed on the light emitting element LD. The second insulating layer INS2 may cover the active layer 12 of the light emitting element LD. For example, the second insulating layer INS2 may include at least one of an organic material or an inorganic material.

According to an embodiment, at least a portion of the second insulating layer INS2 may be located on the lower surface of the light emitting element LD. In this case, the second insulating layer INS2 may fill at least a portion of a groove formed on the lower surface of the light emitting element LD.

The first contact electrode CNE1 and the second contact electrode CNE2 may be disposed on the first insulating layer INS1. The first contact electrode CNE1 may electrically connect the first electrode ELT1 to the light emitting element LD, while the second contact electrode CNE2 may electrically connect the second electrode ELT2 to the light emitting element LD.

The first contact electrode CNE1 and the second contact electrode CNE2 may be formed of a conductive material. For example, the first contact electrode CNE1 and the second contact electrode CNE2 may include clear conductive materials including indium tin oxide (ITO), indium zinc oxide (IZO), and indium tin zinc oxide (ITZO). However, the disclosure is not limited thereto.

The arrangement relationship of the light emitting element LD, the electrode, etc. is not limited to the example described above with reference to FIG. 6, and arrangement relationships according to various modifications may be implemented.

In an embodiment, although not shown in the drawing, the display element part DPL may further include a planarization layer and/or an additional insulating layer, which is disposed on the first contact electrode CNE1 and the second contact electrode CNE2.

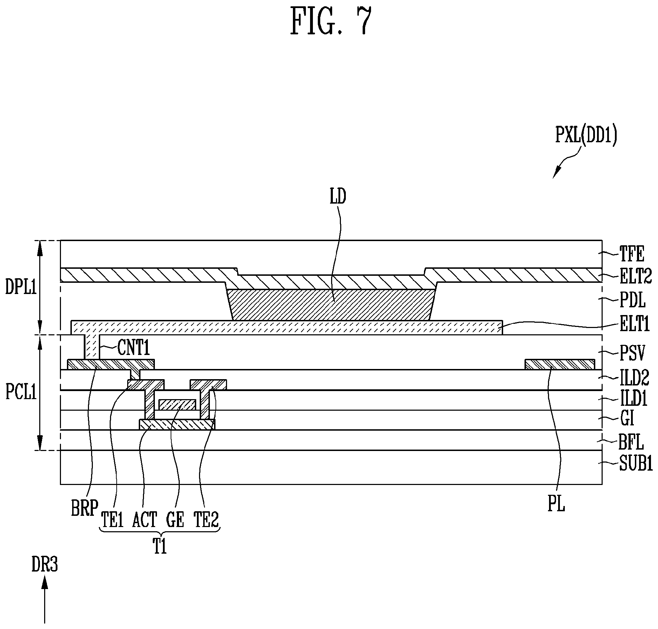

An embodiment where a light emitting element LD is an organic light emitting diode, as a pixel PXL according to a second embodiment, will be described with reference to FIG. 7. FIG. 7 is a schematic cross-sectional view illustrating a pixel in accordance with a second embodiment of the disclosure.

Referring to FIG. 7, the pixel PXL according to the second embodiment is different from the pixel PXL (see FIGS. 5 and 6) according to the first embodiment at least in that the light emitting element LD is the organic light emitting diode.

Referring to FIG. 7, the light emitting element LD may be implemented as an organic light emitting diode. According to an embodiment, the light emitting element LD may be the organic light emitting diode.

According to an embodiment, the light emitting element LD may be disposed in an area defined by a pixel defining layer PDL. A first surface of the light emitting element LD may be electrically connected to the first electrode ELT1, and a second surface of the light emitting element LD may be electrically connected to the second electrode ELT2.

The first electrode ELT1 may be an anode electrode for the light emitting element LD, while the second electrode ELT2 may be a common electrode (or cathode electrode) for the light emitting element LD.

In an embodiment, the light emitting element LD may have a multi-layer thin-film structure including a light generation layer. The light emitting element LD may include a hole injection layer into which holes are injected, a hole transport layer which has desirable hole transportation performance and restrains movement of electrons that have not been recombined with holes in the light generation layer and thus increases chances of recombination between holes and electrons, the light generation layer which emits light by recombination between injected electrons and holes, a hole blocking layer which restrains movement of holes that have not been recombined with electrons in the light generation layer, an electron transport layer which is provided to smoothly transport electrons to the light generation layer, and an electron injection layer into which electrons are injected. The light emitting element LD may emit light in response to electrical signals provided from the first electrode ELT1 and the second electrode ELT2.

In an embodiment, the display element part DPL may include a pixel defining layer PDL and a thin-film encapsulation layer TFE.

The pixel defining layer PDL may define a position where the light emitting element LD implemented as the organic light emitting diode is arranged. The pixel defining layer PDL may include an organic material. For example, the pixel defining layer PDL may include at least one of acryl resin, epoxy resin, phenolic resin, polyamide resin, and polyimide resin, but the disclosure is not limited thereto.

The thin-film encapsulation layer TFE may be disposed on the second electrode ELT2. The thin-film encapsulation layer TFE may cancel a step caused by the light emitting element LD and the pixel defining layer PDL. The thin-film encapsulation layer TFE may include insulating layers configured to cover the light emitting element LD. For example, the thin-film encapsulation layer TFE may have a structure formed by alternately stacking inorganic layers and organic layers.

Hereinafter, the pixel PXL according to an embodiment will be described in connection with the shared layer 100 with reference to FIG. 8. As illustrated in FIG. 8, the first pixel circuit part PCL1 and the first display element part DPL1 are briefly illustrated for the convenience of description. In FIG. 8, an area overlapping the first panel PNL1 is indicated as a portion of the shared layer 100.

FIG. 8 is a schematic cross-sectional view illustrating a pixel including a shared layer, and is a schematic cross-sectional view taken along line I - I' of FIG. 1.

Referring to FIG. 8, the first display element part DPL1 may include a bank BNK. The bank BNK may protrude in the thickness direction of the first substrate SUB1 (the display direction of the tiled display device TDD or the display direction of the first display device DD1, e.g., the third direction DR3).

According to an embodiment, an emission area EMA and a non-emission area NEA may be defined by components included in the first display element part DPL1.

In an embodiment, the emission area EMA may mean an area in which the light emitting element LD is disposed to emit light. The emission area EMA may mean an area in which light is emitted from the first panel PNL1. The non-emission area NEA may be an area other than the emission area EMA and may mean an area in which light is not emitted from the first panel PNL1.

In an embodiment, the bank BNK may define the emission area EMA of the pixel PXL. The bank BNK may have a shape surrounding the emission area EMA. The light emitting element LD may be disposed in an area surrounded by the bank BNK. According to an embodiment, the bank BNK may include an organic material or an inorganic material, but the disclosure is not limited thereto. According to an embodiment, the non-emission area NEA may overlap the bank BNK in a plan view.

According to an embodiment, the emission area EMA may include a first emission area EMA1, a second emission area EMA2, and a third emission area EMA3. The first emission area EMA1 may mean the emission area EMA of the first sub-pixel SPXL1. The second emission area EMA2 may mean the emission area EMA of the second sub-pixel SPXL2. The third emission area EMA3 may mean the emission area EMA of the third sub-pixel SPXL3.

For example, in a plan view, the first emission area EMA1 may overlap a first sub-pixel area SPXA1, the second emission area EMA2 may overlap a second sub-pixel area SPXA2, and the third emission area EMA3 may overlap a third sub-pixel area SPXA3.

The shared layer 100 may be disposed on the first panel PNL1. As described above, the first panel PNL1 and the shared layer 100 may be electrically connected to each other by a method.

According to an embodiment, the shared layer 100 may be disposed on the first panel PNL1. As described above, the shared layer 100 may be provided across the first to fourth panels PNL1 to PNL4. Referring to FIG. 8, the detailed structure of the shared layer 100 will be described.

The shared layer 100 may be provided across the first to third sub-pixels SPXL1, SPXL2, and SPXL3.

The shared layer 100 includes a color conversion part CCL, an optical layer OPL, a color filter part CFL, and an upper film layer UFL.

According to an embodiment, the light emitting elements LD disposed in the first sub-pixel SPXL1, the second sub-pixel SPXL2, and the third sub-pixel SPXL3, respectively, may emit light of a same color. For instance, the first sub-pixel SPXL1, the second sub-pixel SPXL2, and the third sub-pixel SPXL3 may include the light emitting elements LD that emit light of a third color, e.g., blue light. Each of the first sub-pixel SPXL1, the second sub-pixel SPXL2, and the third sub-pixel SPXL3 may be provided with a color conversion part CCL to display a full-color image.

The color conversion part CCL may be a layer included in the shared layer 100 and may be configured to change the wavelength of at least a portion of the light provided from the first display element part DPL1.

The color conversion part CCL may be disposed on the first display element part DPL1. The color conversion part CCL may be provided across the first to third sub-pixels SPXL1, SPXL2, and SPXL3.

Although not shown in FIG. 8, the color conversion part CCL may be provided across the second to fourth panels PNL2, PNL3, and PNL4. For example, another area of the color conversion part CCL may overlap at least one of the second to fourth display element parts DPL2, DPL3, and DPL4 in a plan view.

The color conversion part CCL may include a first capping layer CAP1, a light blocking layer LBL, a first color part 1200, a second color part 1400, a third color part 1600, and a second capping layer CAP2. According to an embodiment, the first color part 1200 may be referred to as a first emission layer, the second color part 1400 may be referred to as a second emission layer, and the third color part 1600 may be referred to as a third emission layer.

The first capping layer CAP1 may be disposed on the first display element part DPL1 to seal (or cover) components disposed between the banks BNK. The first capping layer CAP1 may be disposed between the first display element part DPL1 and the optical layer OPL. The first capping layer CAP1 may be provided across the first to third sub-pixels SPXL1, SPXL2, and SPXL3. The first capping layer CAP1 may prevent impurities such as moisture or air from penetrating therethrough from the outside and thereby damaging or contaminating the first display element part DPL1.

In an embodiment, the first capping layer CAP1 may be formed in a single-layer or multi-layer structure including at least one insulating material of silicon oxide (SiOₓ), silicon nitride (SiNₓ), silicon oxynitride (SiOₓN_{y}), aluminum oxide (AlOₓ), and titanium oxide (TiOₓ). However, the disclosure is not limited thereto.

The first color part 1200 may provide light of a first color. The first color part 1200 may be a component included in the first sub-pixel SPXL1 and allow the light of the first color to be provided in the first sub-pixel area SPXA1. When viewed from an outside, the light of the first color may be observed in the first sub-pixel area SPXA1.

According to an embodiment, the first to third sub-pixel areas SPXA1 to SPXA3 may be defined by the shared layer 100 (or a component included in the shared layer 100).

According to an embodiment, the first sub-pixel area SPXA1 may mean an area in which the light of the first color is emitted. The first sub-pixel area SPXA1 may mean an area in which the light of the first color emitted from the first sub-pixel SPXL1 is provided to the outside. The first sub-pixel area SPXA1 may overlap the first color part 1200, in a plan view.

The second color part 1400 may provide light of a second color. The second color part 1400 may be a component included in the second sub-pixel SPXL2 and allow the light of the second color to be provided in the second sub-pixel area SPXA2. When viewed from an outside, the light of the second color may be observed in the second sub-pixel area SPXA2.

According to an embodiment, the second sub-pixel area SPXA2 may mean an area in which the light of the second color is emitted. The second sub-pixel area SPXA2 may mean an area in which the light of the second color emitted from the second sub-pixel SPXL2 is provided to the outside. The second sub-pixel area SPXA2 may overlap the second color part 1400, in a plan view.

The third color part 1600 may provide light of a third color. The third color part 1600 may be a component included in the third sub-pixel SPXL3 and allow the light of the third color to be provided in the third sub-pixel area SPXA3. When viewed from an outside, the light of the third color may be observed in the third sub-pixel area SPXA3.

According to an embodiment, the third sub-pixel area SPXA3 may mean an area in which the light of the third color is emitted. The third sub-pixel area SPXA3 may mean an area in which the light of the third color emitted from the third sub-pixel SPXL3 is provided to the outside. The third sub-pixel area SPXA3 may overlap the third color part 1600, in a plan view.

The position of the first color part 1200 may be disposed to be misaligned from the first emission area EMA1 when viewed in a plan view. The first color part 1200 may overlap the first emission area EMA1 when viewed in a plan view. According to an embodiment, a portion of the first color part 1200 may overlap the first emission area EMA1, while another portion of the first color part 1200 may not overlap the first emission area EMA1.

The position of the second color part 1400 may be disposed to be misaligned from the second emission area EMA2 when viewed in a plan view. The second color part 1400 may overlap the second emission area EMA2 when viewed in a plan view. According to an embodiment, a portion of the second color part 1400 may overlap the second emission area EMA2, while another portion of the second color part 1400 may not overlap the second emission area EMA2.

The position of the third color part 1600 may be disposed to be misaligned from the third emission area EMA3 when viewed in a plan view. The third color part 1600 may overlap the third emission area EMA3 when viewed in a plan view. According to an embodiment, a portion of the third color part 1600 may overlap the third emission area EMA3, while another portion of the third color part 1600 may not overlap the third emission area EMA3.

According to an embodiment, the first color part 1200 may include first color conversion particles configured to convert the light of the third color provided from the light emitting element LD of the first display element part DPL1 (or the light emitting element LD included in the first sub-pixel SPXL1) into the light of the first color. For example, in case that the light emitting element LD is a blue light emitting element configured to emit blue light and the first sub-pixel SPXL1 is a red pixel, the first color part 1200 may include a first quantum dot that converts blue light emitted from the blue light emitting element into red light.

For example, the first color part 1200 may include first quantum dots dispersed in a matrix material such as base resin. The first quantum dot may absorb blue light and shift a wavelength of light according to energy transition to emit red light.

According to an embodiment, the second color part 1400 may include second color conversion particles configured to convert the light of the third color provided from the light emitting element LD of the first display element part DPL1 (or the light emitting element LD included in the second sub-pixel SPXL2) into the light of the second color. For example, in case that the light emitting element LD is a blue light emitting element configured to emit blue light and the second sub-pixel SPXL2 is a green pixel, the second color part 1400 may include a second quantum dot that converts blue light emitted from the blue light emitting element into green light.

For example, the second color part 1400 may include second quantum dots dispersed in a matrix material such as base resin. The second quantum dot may absorb blue light and shift a wavelength of light according to energy transition to emit green light.

Each of the first and second quantum dots may be in the form of a nanoparticle, a nanotube, a nanowire, a nanofiber, a planar nanoparticle having a spherical shape, a pyramidal shape, a multi-arm shape, or a cubic shape, but the disclosure is not limited thereto. The shape of each of the first and second quantum dots may be changed in various ways.

According to an embodiment, the third color part 1600 may be provided to efficiently use the light of the third color emitted from the light emitting element LD of the first display element part DPL1 (or the light emitting element LD included in the third sub-pixel SPXL3). For example, in case that the light emitting element LD is a blue light emitting element configured to emit blue light and the third sub-pixel SPXL3 is a blue pixel, the third color part 1600 may include at least one type of light scattering particles to efficiently use the light emitted from the light emitting element LD.

For example, the third color part 1600 may include light scattering particles dispersed in a matrix material such as base resin. For example, the third color part 1600 may include light scattering particles such as silica, but a material forming the light scattering particles is not limited thereto.

The light scattering particles do not have to be disposed only in an area corresponding to the third sub-pixel SPXL3. For example, the light scattering particles may be selectively provided in the first color part 1200 and the second color part 1400.

According to an embodiment, the pixel PXL may further include a light scattering layer disposed under the color conversion part CCL. The light scattering layer may include light scattering particles configured to scatter the light. The light scattering layer may be provided across the first to third sub-pixels SPXL1, SPXL2, and SPXL3. The light scattering layer may concentrate light on a specific position to prevent a phenomenon in which the color is not uniformly provided. As the color conversion part CCL is disposed, the reliability of implementing colors may be improved.

The light blocking layer LBL may be disposed on the first display element part DPL1. The light blocking layer LBL may be disposed between the first capping layer CAP1 and the second capping layer CAP2. The light blocking layer LBL may be disposed to surround the first to third color parts 1200, 1400, and 1600 at boundaries between the first to third sub-pixels SPXL1, SPXL2, and SPXL3.

According to an embodiment, the light blocking layer LBL may define the first to third sub-pixel areas SPXA1, SPXA2, and SPXA3.

For example, an area in which the light blocking layer LBL is not disposed may be at least one of the first to third sub-pixel areas SPXA1, SPXA2, and SPXA3. Light may not be substantially emitted from areas in which the light blocking layer LBL is disposed.

According to an embodiment, the light blocking layer LBL may be disposed to be misaligned from the emission area EMA. For example, a portion of the light blocking layer LBL may overlap the emission area EMA in a plan view, while another portion of the light blocking layer LBL may not overlap the emission area EMA in a plan view. For example, a portion of the light blocking layer LBL may overlap the bank BNK, while another portion of the light blocking layer LBL may not overlap the bank BNK.

According to an embodiment, the light blocking layer LBL may be formed of an organic material including at least one of graphite, carbon black, black pigment, and black dye, or be formed of a metal material including chromium (Cr). However, any material is possible as long as this may block the transmission of light and absorb light.

The second capping layer CAP2 may seal (or cover) the first to third color parts 1200, 1400, and 1600. The second capping layer CAP2 may be disposed between the optical layer OPL and the first capping layer CAP1. The second capping layer CAP2 may be provided across the first to third sub-pixels SPXL1, SPXL2, and SPXL3. The second capping layer CAP2 may prevent impurities such as moisture or air from penetrating therethrough from the outside and thereby damaging or contaminating the first to third color parts 1200, 1400, and 1600.

In an embodiment, the second capping layer CAP2 may be formed in a single-layer or multi-layer structure including at least one insulating material of silicon oxide (SiOₓ), silicon nitride (SiNₓ), silicon oxynitride (SiOₓN_{y}), aluminum oxide (AlOₓ), and titanium oxide (TiOₓ). However, the disclosure is not limited thereto.

The optical layer OPL may be a layer for improving optical efficiency. The optical layer OPL may be disposed on the color conversion part CCL. The optical layer OPL may include a low refractive layer LRL and a third capping layer CAP3.

The low refractive layer LRL may be disposed between the second capping layer CAP2 and the third capping layer CAP3. The low refractive layer LRL may be disposed between the color conversion part CCL and the color filter part CFL. The low refractive layer LRL may be provided across the first to third sub-pixels SPXL1, SPXL2, and SPXL3.

The low refractive layer LRL may recycle light provided from the color conversion part CCL by total reflection, thus improving optical efficiency. To this end, the low refractive layer LRL may have a refractive index that is relatively lower than that of the color conversion part CCL.

According to an embodiment, the low refractive layer LRL may include a base resin and hollow particles dispersed in the base resin. The hollow particles may include hollow silica particles. As another example, the hollow particles may be pores formed by porogen, but the disclosure is not limited thereto. Further, the low refractive layer LRL may include at least one of zinc oxide (ZnO) particles, titanium dioxide (TiO₂) particles, and nano silicate particles, but the disclosure is not limited thereto.

The third capping layer CAP3 may be disposed on the low refractive layer LRL. The third capping layer CAP3 may be disposed between the color filter part CFL and the low refractive layer LRL. The third capping layer CAP3 may be provided across the first to third sub-pixels SPXL1, SPXL2, and SPXL3. The third capping layer CAP3 may prevent impurities such as moisture or air from penetrating therethrough from the outside and thereby damaging or contaminating the low refractive layer LRL.

In an embodiment, the third capping layer CAP3 may be formed in a single-layer or multi-layer structure including at least one insulating material of silicon oxide (SiOₓ), silicon nitride (SiNₓ), silicon oxynitride (SiOₓN_{y}), aluminum oxide (AlOₓ), and titanium oxide (TiOₓ). However, the disclosure is not limited thereto.

The color filter part CFL may be disposed on the third capping layer CAP3. The color filter part CFL may be provided across the first to third sub-pixels SPXL1, SPXL2, and SPXL3. The color filter part CFL may include color filters CF1, CF2, and CF3, a planarization layer PLA, and an overcoat layer OC.

According to an embodiment, the color filters CF1, CF2, and CF3 may be disposed on the third capping layer CAP3. In a plan view, the color filters CF1, CF2, and CF3 may overlap the first to third sub-pixel areas SPXA1, SPXA2, and SPXA3, respectively. For example, the first color filter CF1 may overlap the first sub-pixel area SPXA1, the second color filter CF2 may overlap the second sub-pixel area SPXA2, and the third color filter CF3 may overlap the third sub-pixel area SPXA3.

According to an embodiment, the first color filter CF1 may transmit the light of the first color, but may not transmit the light of the second color and the light of the third color. For example, the first color filter CF1 may include a colorant for the first color.

According to an embodiment, the second color filter CF2 may transmit the light of the second color, but may not transmit the light of the first color and the light of the third color. For example, the second color filter CF2 may include a colorant for the second color.

According to an embodiment, the third color filter CF3 may transmit the light of the third color, but may not transmit the light of the first color and the light of the second color. For example, the third color filter CF3 may include a colorant for the third color.

According to an embodiment, the planarization layer PLA may be disposed on the color filters CF1, CF2, and CF3. The planarization layer PLA may cover the color filters CF1, CF2, and CF3. The planarization layer PLA may cancel a step caused by the color filters CF1, CF2, and CF3. The planarization layer PLA may be provided across the first to third sub-pixels SPXL1, SPXL2, and SPXL3.

For example, the planarization layer PLA may include an organic material such as acrylates resin, epoxy resin, phenolic resin, polyamides resin, polyimides resin, polyesters resin, polyphenylene sulfides resin, or benzocyclobutene (BCB). However, the disclosure is not limited thereto. The planarization layer PLA may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The overcoat layer OC may be disposed on the planarization layer PLA. The overcoat layer OC may be disposed between the upper film layer UFL and the color filter part CFL. The overcoat layer OC may be provided across the first to third sub-pixels SPXL1, SPXL2, and SPXL3. The overcoat layer OC may cover a lower member including the color filter part CFL. The overcoat layer OC may prevent moisture or air from penetrating into the above-described lower member. The overcoat layer OC may protect the above-described lower member from foreign substances such as dust.

In an embodiment, the overcoat layer OC may include an organic material such as acrylates resin, epoxy resin, phenolic resin, polyamides resin, polyimides resin, polyesters resin, polyphenylene sulfides resin, or benzocyclobutene (BCB). However, the disclosure is not limited thereto. The overcoat layer OC may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The upper film layer UFL may be disposed on the color filter part CFL. The upper film layer UFL may be disposed outside the first display device DD1 to reduce external influence on the first display device DD1. The upper film layer UFL may be provided across the first to third sub-pixels SPXL1, SPXL2, and SPXL3.

In some embodiments, the upper film layer UFL may include a transparent film. For example, the transparent film may be at least one of a polyethylene terephthalate (PET) film, a low reflection film, a polarizing film, and a transmittance controllable film, but the disclosure is not limited thereto.

According to an embodiment, the upper film layer UFL may include an anti-reflective (AR) coating layer for reducing reflectance of light incident from the outside. The AR coating layer may refer to a configuration in which a material having an anti-reflection function is applied to a surface of a specific configuration. The applied material may have a low reflectance. For example, the material used for the AR coating layer may include at least one of silicon oxide (SiOₓ), zirconium oxide (ZiOₓ), aluminum oxide (AlₓO_{y}), and titanium oxide (TiOₓ). However, the disclosure is not limited thereto, and various materials may be used.

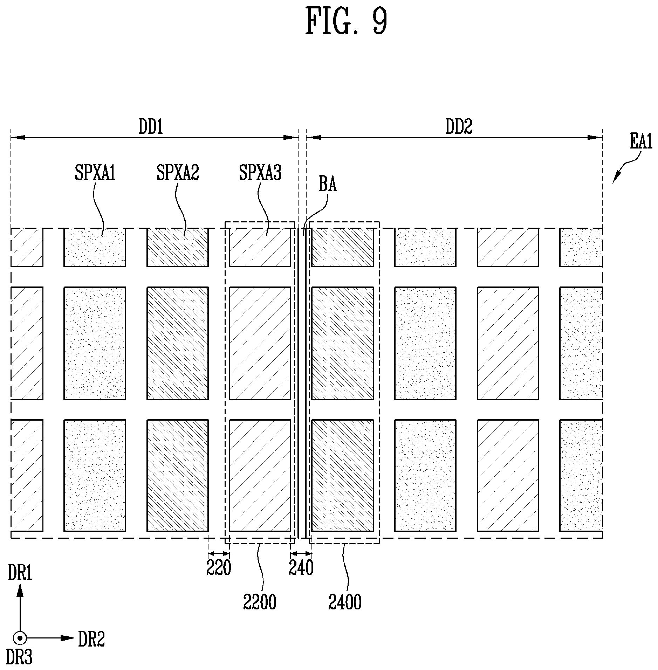

Hereinafter, reasons for improved visibility of the tiled display device TDD in accordance with an embodiment will be described with reference to FIGS. 9 to 11.

FIGS. 9 to 11 are schematic enlarged views illustrating area EA1 of FIG. 1. For the convenience of description, in FIGS. 9 to 11, the first display device DD1 and the second display device DD2, which are adjacent to each other, among the display devices DD included in the tiled display device TDD will be mainly described. The technical features of each of the first display device DD1 and the second display device DD2 and an connection relationship therebetween may be applied to the third display device DD3 and the fourth display device DD4.

FIGS. 9 to 11 illustrate an area of a portion of each of the first display device DD1 and the second display device DD2.

FIG. 9 illustrates specified first to third sub-pixel areas SPXA1, SPXA2, and SPXA3 in a plan view.

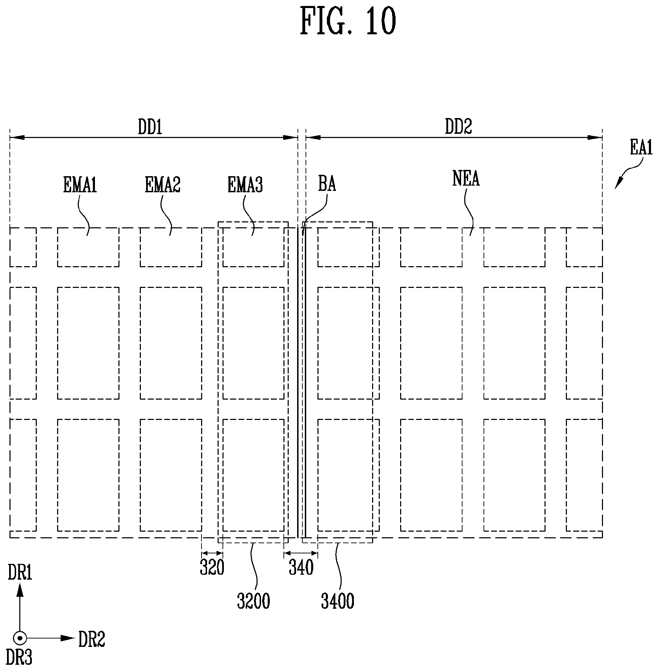

FIG. 10 illustrates specified first to third emission areas EMA1, EMA2, and EMA3 in a plan view.

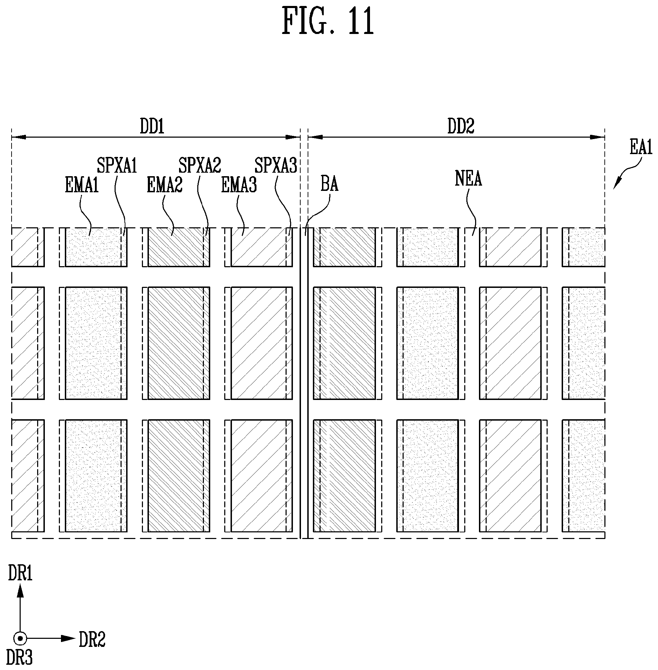

FIG. 11 illustrates a state in which FIGS. 9 and 10 overlap to represent a positional relationship between the first to third sub-pixel areas SPXA1, SPXA2, and SPXA3 and the first to third emission areas EMA1, EMA2, and EMA3.

First, referring to FIG. 9, the first to third sub-pixel areas SPXA1, SPXA2, and SPXA3 may be arranged in a pattern. For example, FIG. 9 illustrates an embodiment in which the first to third sub-pixel areas SPXA1, SPXA2, and SPXA3 are arranged in the first direction DR1, but the disclosure is not limited thereto.

According to an embodiment, the first to third sub-pixel areas SPXA1, SPXA2, and SPXA3 which are adjacent to each other in the first display device DD1 may be spaced apart from each other by a first separation distance 220. The first to third sub-pixel areas SPXA1, SPXA2, and SPXA3 which are adjacent to each other in the second display device DD2 may be spaced apart from each other by the first separation distance 220.

For example, in the display devices DD, the first to third sub-pixel areas SPXA1, SPXA2, and SPXA3 may be spaced apart from each other in the second direction DR2 by the first separation distance 220. In the first display device DD1, the first sub-pixel area SPXA1 and the second sub-pixel area SPXA2 may be spaced apart from each other by the first separation distance 220. In the first display device DD1, the second sub-pixel area SPXA2 and the third sub-pixel area SPXA3 may be spaced apart from each other by the first separation distance 220. In the second display device DD2, the first sub-pixel area SPXA1 and the second sub-pixel area SPXA2 may be spaced apart from each other by the first separation distance 220. In the second display device DD2, the second sub-pixel area SPXA2 and the third sub-pixel area SPXA3 may be spaced apart from each other by the first separation distance 220.

In an embodiment, a first adjacent sub-pixel area 2200 may be spaced apart from a second adjacent sub-pixel area 2400 by a second separation distance 240. For example, the first adjacent sub-pixel area 2200 may be spaced apart from the second adjacent sub-pixel area 2400 in the second direction DR2 by the second separation distance 240.

The first adjacent sub-pixel area 2200 may mean a sub-pixel area that is closest to the adjacent second display device DD2, among the first to third sub-pixel areas SPXA1, SPXA2, and SPXA3 disposed in the first display device DD1. The second adjacent sub-pixel area 2400 may mean a sub-pixel area that is closest to the adjacent first display device DD1, among the first to third sub-pixel areas SPXA1, SPXA2, and SPXA3 disposed in the second display device DD2.

In an embodiment, a color represented by the first adjacent sub-pixel area 2200 and a color represented by the second adjacent sub-pixel area 2400 may be different from each other.

In an embodiment, the first adjacent sub-pixel area 2200 and the second adjacent sub-pixel area 2400 may be spaced apart from each other with the bonding area BA being interposed therebetween. The thickness of the bonding area BA (e.g., a separation distance between the first panel PNL1 of the first display device DD1 and the second panel PNL2 of the second display device DD2) may be smaller than the second separation distance 240. However, the disclosure is not limited thereto.

In an embodiment, the bonding area BA may be disposed to be misaligned from an area between the first adjacent sub-pixel area 2200 and the second adjacent sub-pixel area 2400 defining the second separation distance 240.

Referring to FIG. 10, the first to third emission areas EMA1, EMA2, and EMA3 may be arranged in a pattern. For example, FIG. 10 illustrates an embodiment in which the first to third emission areas EMA1, EMA2, and EMA3 are arranged in the first direction DR1, but the disclosure is not limited thereto.

According to an embodiment, the first to third emission areas EMA1, EMA2, and EMA3 which are adjacent to each other in the first display device DD1 may be spaced apart from each other by a first emission separation distance 320. The first to third emission areas EMA1, EMA2, and EMA3 which are adjacent to each other in the second display device DD2 may be spaced apart from each other by the first emission separation distance 320.

For example, in the display devices DD, the first to third emission areas EMA1, EMA2, and EMA3 may be spaced apart from each other in the second direction DR2 by the first emission separation distance 320.

In the first display device DD1, the first emission area EMA1 and the second emission area EMA2 may be spaced apart from each other by the first emission separation distance 320. In the first display device DD1, the second emission area EMA2 and the third emission area EMA3 may be spaced apart from each other by the first emission separation distance 320. In the second display device DD2, the first emission area EMA1 and the second emission area EMA2 may be spaced apart from each other by the first emission separation distance 320. In the second display device DD2, the second emission area EMA2 and the third emission area EMA3 may be spaced apart from each other by the first emission separation distance 320.

In an embodiment, a first adjacent emission area 3200 may be spaced apart from a second adjacent emission area 3400 by a second emission separation distance 340. For example, the first adjacent emission area 3200 may be spaced apart from the second adjacent emission area 3400 in the second direction DR2 by the second emission separation distance 340.

The first adjacent emission area 3200 may mean an emission area that is closest to the adjacent second display device DD2, among the first to third emission areas EMA1, EMA2, and EMA3 disposed in the first display device DD1. The second adjacent emission area 3400 may mean an emission area that is closest to the adjacent first display device DD1, among the first to third emission areas EMA1, EMA2, and EMA3 disposed in the second display device DD2.

According to an embodiment, the thickness of the bonding area BA may be smaller than the second emission separation distance 340. For instance, in a plan view, the bonding area BA may overlap an area between the first adjacent emission area 3200 and the second adjacent emission area 3400 defining the second emission separation distance 340.

According to an embodiment, the first emission separation distance 320 and the second emission separation distance 340 may be different from each other. For example, the first emission separation distance 320 may be smaller than the second emission separation distance 340.

According to an embodiment, the second emission separation distance 340 may be greater than the second separation distance 240.

In order to manufacture the tiled display device TDD, the first display device DD1 and the second display device DD2 may be respectively manufactured and connected to each other. In the first display device DD1, the emission areas EMA may be manufactured to be spaced apart from each other by the first emission separation distance 320. In the second display device DD2, the emission areas EMA may be manufactured to be spaced apart from each other by the first emission separation distance 320. In case that the first display device DD1 and the second display device DD2 are connected to each other, the first adjacent emission area 3200 and the second adjacent emission area 3400 may be spaced apart from each other by the second emission separation distance 340 that is different from the first emission separation distance 320.

Experimentally, since the first emission separation distance 320 and the second emission separation distance 340 are different from each other, the bonding area BA may be visually recognized to the outside. In this case, the visibility of the tiled display device TDD may be impaired.

However, according to an embodiment, the shared layer 100 forming (or configuring) the upper panel of the tiled display device TDD may be provided, so that external visibility may be improved.

To be more specific, referring to FIG. 11, the first to third sub-pixel areas SPXA1, SPXA2, and SPXA3 defined by components included in the shared layer 100 may be arranged in a pattern regardless of the structure of the individual components of the first panel PNL1 and the second panel PNL2.

Furthermore, the first to third sub-pixel areas SPXA1, SPXA2, and SPXA3 defined by the components included in the shared layer 100 may be arranged in a pattern, separately from the arrangement structure of the first to third emission areas EMA1, EMA2, and EMA3 defined by components forming a lower panel. Referring to FIG. 11, according to an embodiment, it can be seen that the first to third sub-pixel areas SPXA1, SPXA2, and SPXA3 and the first to third emission areas EMA1, EMA2, and EMA3 are disposed to be misaligned from each other.

For example, a separation distance between the first to third sub-pixel areas SPXA1, SPXA2, and SPXA3 in the first display device DD1, a separation distance between the first to third sub-pixel areas SPXA1, SPXA2, and SPXA3 in the second display device DD2, and a separation distance between the first to third sub-pixel areas SPXA1, SPXA2, and SPXA3 in an area where the first display device DD1 and the second display device DD2 are adjacent to each other may be substantially equal to each other.

In this case, even when a separation distance between the first to third emission areas EMA1, EMA2, and EMA3 defined by the components (e.g., the components of the first panel PNL1 and the second panel PNL2) forming the lower panel of the tiled display device TDD is partially non-uniform, external visibility may not be impaired.

According to an embodiment, the first to third sub-pixel areas SPXA1, SPXA2, and SPXA3 may be greater than the first to third emission areas EMA1, EMA2, and EMA3, respectively.

For example, at least a portion of the first sub-pixel area SPXA1 may protrude without overlapping the first emission area EMA1, in a plan view. The first emission area EMA1 may be provided to be included in the first sub-pixel area SPXA1 in a plan view. At least a portion of the second sub-pixel area SPXA2 may protrude without overlapping the second emission area EMA2, in a plan view. The second emission area EMA2 may be provided to be included in the second sub-pixel area SPXA2 in a plan view. At least a portion of the third sub-pixel area SPXA3 may protrude without overlapping the third emission area EMA3, in a plan view. The third emission area EMA3 may be provided to be included in the third sub-pixel area SPXA3 in a plan view.

However, the disclosure is not limited to the above-described example. For example, the first to third sub-pixel areas SPXA1, SPXA2, and SPXA3 may be equal to or smaller than the first to third emission areas EMA1, EMA2, and EMA3.

According to an embodiment, since the color conversion part CCL and the color filter part CFL are provided in the shared layer 100, external visibility may be improved. As described above with reference to FIG. 8, the color conversion part CCL and the color filter part CFL disposed across the display devices DD may be provided in the shared layer 100. Particularly, the color conversion part CCL may include a first color part 1200 configured to emit light of a first color, a second color part 1400 configured to emit light of a second color, and a third color part 1600 configured to emit light of a third color. In this case, when viewed from the outside, the first sub-pixel SPXL1 emitting light of the first color, the second sub-pixel SPXL2 emitting light of the second color, and the third sub-pixel SPXL3 emitting light of the third color may be defined by the structure of the color conversion part CCL included in the shared layer 100. In other words, even when the first to third emission areas EMA1, EMA2, and EMA3 are partially non-uniformly disposed (particularly, near the bonding area BA) in the lower panel, they may not be visually recognized from the outside.

Further, since the color conversion part CCL and the color filter part CFL may be formed by a photo or photolithography process or a print process, they may be performed over a large area, and thus process productivity may be improved.

Furthermore, according to an embodiment, the bonding area BA may be recognized as a spaced area or gap between the adjacent first to third sub-pixel areas SPXA1, SPXA2, and SPXA3, and thus an external visibility issue in the bonding area BA, which may occur in the related art, can be solved.

The above description is merely illustrative of the technical idea of the disclosure, and it is apparent to those of ordinary skill in the art that the disclosure may be changed and modified in various ways without departing from the scope of the disclosure. Therefore, the above-described embodiments may be implemented separately or in combination.

Therefore, as the embodiments are illustrative and not restrictive, it should be understood that the disclosure is not limited to the specific embodiments. All technical ideas within an equivalent scope should be interpreted as being included in the scope of the disclosure.

According to an embodiment, it is possible to provide a tiled display device, in which external visibility is improved and process productivity is improved.

The disclosure is not limited to the above-described effects, and other effects that are not mentioned will be clearly understood by those skilled in the art from the specification and the accompanying drawings.

## Claims

1. A tiled display device (TDD) comprising:
a first panel (PNL1) including a first display element layer (DPL1);
a second panel (PNL2) including a second display element layer (DPL2);
a shared layer (100) including a color conversion part (CCL);
wherein the shared layer (100) includes a first portion and a second portion;
wherein the first portion overlaps with the first panel (PNL1) in a plan view,
wherein the second portion overlaps with the second panel (PNL2) in a plan view, and
wherein the color conversion part (CCL) is configured to change a wavelength of light provided from the first panel (PNL1) and the second panel (PNL2), wherein
the color conversion part (CCL) comprises:
a first color part (1200) providing light of a first color;
a second color part (1400) providing light of a second color; and
a third color part (1600) providing light of a third color, and
the first color part (1200), the second color part (1400), and the third color part (1600) overlap the first panel (PNL1) and the second panel (PNL2) in a plan view;
a first sub-pixel area (SPXA1) emitting the light of the first color and overlapping the first color part (1200) in a plan view;
a second sub-pixel area (SPXA2) emitting the light of the second color and overlapping the second color part (1400) in a plan view; and
a third sub-pixel area (SPXA3) emitting the light of the third color and overlapping the third color part (1600) in a plan view,
wherein the first display element layer (DPL1) includes a first light emitting element, and the second display element layer (DPL2) includes a second light emitting element, wherein the tiled display device (TDD) further comprises:
an emission area (EMA) in which the first light emitting element and the second light emitting element are disposed,
wherein the emission area (EMA) is defined by components included in the first display element layer (DPL1) and the second display element layer (DPL2), optionally wherein
each of the first display element layer (DPL1) and the second display element layer (DPL2) include a bank (BNK) protruding in a display direction of the tiled display device (TDD), and
the bank (BNNK) has a shape enclosing the emission area (EMA),
wherein the emission area (EMA) comprises:
a first emission area (EMA1) overlapping the first sub-pixel area (SPXA1) in a plan view;
a second emission area (EMA2) overlapping the second sub-pixel area (SPXA2) in a plan view; and
a third emission area (EMA3) overlapping third sub-pixel area (SPXA3) in a plan view, and
**characterized in that**
the first color part (1200) is disposed to be misaligned from the first emission area (EMA1) in a plan view,
the second color part (1400) is disposed to be misaligned from the second emission area (EMA2) in a plan view, and
the third color part (1600) is disposed to be misaligned from the third emission area (EMA3) in a plan view.

2. The tiled display device (TDD) according to claim 1, wherein the first panel (PNL1) and the second panel (PNL2) form a lower panel of the tiled display device (TDD), and the shared layer (100) forms an upper panel of the tiled display device (TDD).

3. The tiled display device (TDD) according to claim 1 or 2, wherein
the first panel (PNL1) and the second panel (PNL2) are disposed on a same layer,
the first panel (PNL1) and the second panel (PNL2) are spaced apart from each other, and
a bonding area (BA) is disposed between the first panel (PNL1) and the second panel (PNL2).

4. The tiled display device (TDD) according to claim 3, wherein the bonding area (BA) overlaps the shared layer (100) in a plan view.

5. The tiled display device (TDD) according to any preceding claim, wherein the shared layer (100) further comprises:
a first color filter (CF1) overlapping the first sub-pixel area (SPXA1) in a plan view;
a second color filter (CF2) overlapping the second sub-pixel area (SPXA2) in a plan view; and
a third color filter (CF3) overlapping the third sub-pixel area (SPXA3) in a plan view.

6. The tiled display device according to claim 5, each of the first display element layer (DPL1) and the second display element layer (DPL2) include a bank (BNK) protruding in a display direction of the tiled display device (TDD), and
the bank (BNK) has a shape enclosing the emission area (EMA).

7. The tiled display device (TDD) according to any preceding claim, wherein
at least part of the first color part (1200) overlaps the first emission area (EMA1) in a plan view, and
other part of the first color part (1200) does not overlap the first emission area (EMA1) in a plan view.

8. The tiled display device (TDD) according to any preceding claim, wherein
the first panel (PNL1) and the first portion of the shared layer (100) form a first display device (DD1),
the second panel (PNL1) and the second portion of the shared layer (100) form a second display device (DD2),
in the first display device (DD1) and the second display device (DD2), the first sub-pixel area (SPXA1), the second sub-pixel area (SPXA2), and the third sub-pixel area (SPXA3) are adjacent to each other and are spaced apart from each other by a first separation distance (220),
a first adjacent sub-pixel area (2200) of the first display device (DD1) and a second adjacent sub-pixel area (2400) of the second display device (DD2) are spaced apart from each other by a second separation distance (240),
the first adjacent sub-pixel area (2200) is an area closest to the second display device (DD2), among the first sub-pixel area (SPXA1), the second sub-pixel area (SPXA2), and the third sub-pixel area (SPXA3) disposed in the first display device (DD1),
the second adjacent sub-pixel area (2400) is an area closest to the first display device (DD1), among the first sub-pixel area (SPXA1), the second sub-pixel area (SPXA2), and the third sub-pixel area (SPXA3) disposed in the second display device (DD2), and
the first separation distance (220) is equal to the second separation distance (240).
optionally a color provided by the first adjacent sub-pixel area (2200) and a color provided by the second adjacent sub-pixel area (2400) are different from each other.

9. The tiled display device according to claim 8, wherein
in the first display device (DD1) and the second display device (DD2), the first emission area (EMA1), the second emission area (EMA2), and the third emission area (EMA3) are adjacent to each other and are spaced apart from each other by a first emission separation distance (320),
a first adjacent emission area (3200) of the first display device (DD1) and a second adjacent emission area (3400) of the second display device (DD2) are spaced apart from each other by a second emission separation distance (340),
the first adjacent emission area (3200) is an area closest to the second display device (DD2), among the first emission area (EMA1), the second emission area (EMA2), and the third emission area (EMA3) disposed in the first display device (DD1),
the second adjacent emission area (3400) is an area closest to the first display device (DD1), among the first emission area (EMA1), the second emission area (EMA2), and the third emission area (EMA3) disposed in the second display device (DD2), and
the first emission separation distance (320) is different from the second emission separation distance (340), optionally the second emission separation distance (340) is greater than the second separation distance (240).

10. The tiled display device according to claim 9, wherein, when viewed from an outside,
the light of the first color is observed in the first sub-pixel area (SPXA1),
the light of the second color is observed in the second sub-pixel area (SPXA2), and
the light of the third color is observed in the third sub-pixel area (SPXA3).

11. The tiled display device according to claim 9 or 10, wherein
the first panel (PNL1) and the second panel (PNL2) are disposed on a same layer,
the first panel (PNL1) and the second panel (PNL2) are spaced apart from each other,
a bonding area (BA) is disposed between the first panel (PNL1) and the second panel (PNL2), and
a thickness of the bonding area (BA) is smaller than the second separation distance (240).

12. The tiled display device according to any preceding claim, wherein
the first color part (1200) comprises a first quantum dot converting the light of the third color into the light of the first color, and
the second color part (1400) comprises a second quantum dot converting the light of the third color into the light of the second color.

13. The tiled display device according to claim 12, wherein the first display element layer (DPL1) includes a first light emitting element, and the second display element layer (DPL2) includes a second light emitting element, and
wherein each of the first light emitting element and second light emitting element emit the light of the third color.

14. The tiled display device (TDD) according to any one preceding claim, wherein the first display element layer (DPL1) includes a first light emitting element, and the second display element layer (DPL2) includes a second light emitting element, and
wherein the first light emitting element and the second light emitting element are an organic light emitting diode or a light emitting diode having a size in a range of a nanoscale to a microscale.

15. A tiled display device (TDD) comprising:
a first panel (PNL1) including a first display element layer (DPL1);
a second panel (PNL2) including a second display element layer (DPL2);
a shared layer (100) including a color conversion part (CCL);
wherein the shared layer (100) includes a first portion and a second portion;
wherein the first portion overlaps with the first panel (PNL1) in a plan view,
wherein the second portion overlaps with the second panel (PNL2) in a plan view, and
wherein the color conversion part (CCL) is configured to change a wavelength of light provided from the first panel (PNL1) and the second panel (PNL2), wherein
the color conversion part (CCL) comprises:
a first color part (1200) providing light of a first color;
a second color part (1400) providing light of a second color; and
a third color part (1600) providing light of a third color, and
the first color part (1200), the second color part (1400), and the third color part (1600) overlap the first panel (PNL1) and the second panel (PNL2) in a plan view,
a first sub-pixel area (SPXA1) emitting the light of the first color and overlapping the first color part (1200) in a plan view;
a second sub-pixel area (SPXA2) emitting the light of the second color and overlapping the second color part (1400) in a plan view; and
a third sub-pixel area (SPXA3) emitting the light of the third color and overlapping the third color part (1600) in a plan view,
wherein the first display element layer (DPL) includes a first light emitting element, and the second display element layer (DPL2) includes a second light emitting element, wherein the tiled display device (TDD) further comprises:
an emission area (EMA) in which the first light emitting element and the second light emitting element are disposed,
wherein the emission area (EMA) is defined by components included in the first display element layer (DPL1) and the second display element layer (DPL2), optionally wherein
each of the first display element layer (DPL1) and the second display element layer (DPL2) include a bank (BNK) protruding in a display direction of the tiled display device (TDD), and
the bank (BHK) has a shape enclosing the emission area (EMA),
wherein the emission area (EMA) comprises:
a first emission area (EMA1) overlapping the first sub-pixel area (SPXA1) in a plan view;
a second emission area (EMA2) overlapping the second sub-pixel area (SPXA2) in a plan view; and
a third emission area (EMA3) overlapping third sub-pixel area (SPXA3) in a plan view, wherein
the first panel (PNL1) and the first portion of the shared layer (100) form a first display device (DD1),
the second panel (PNL2) and the second portion of the shared layer (100) form a second display device (DD2),
in the first display device (DD1) and the second display device (DD2), the first sub-pixel area (SPXA1), the second sub-pixel area (SPXA2), and the third sub-pixel area (SPXA3) are adjacent to each other and are spaced apart from each other by a first separation distance (220),
a first adjacent sub-pixel area (2200) of the first display device (DD1) and a second adjacent sub-pixel area (2400) of the second display device (DD2) are spaced apart from each other by a second separation distance (240),
the first adjacent sub-pixel area (2200) is an area closest to the second display device (DD2), among the first sub-pixel area (SPXA1), the second sub-pixel area (SPXA2), and the third sub-pixel area (SPXA3) disposed in the first display device (DD1),
the second adjacent sub-pixel area (2400) is an area closest to the first display device (DD1), among the first sub-pixel area (SPXA1), the second sub-pixel area (SPXA2), and the third sub-pixel area (SPXA3) disposed in the second display device (DD2), and
the first separation distance (220) is equal to the second separation distance (240).
optionally a color provided by the first adjacent sub-pixel area (2200) and a color provided by the second adjacent sub-pixel area (2400) are different from each other, and
wherein,
in the first display device (DD1) and the second display device (DD2), the first emission area (EMA1), the second emission area (EMA2), and the third emission area (EMA3) are adjacent to each other and are spaced apart from each other by a first emission separation distance (320),
a first adjacent emission area (320) of the first display device (DD1) and a second adjacent emission area (3400) of the second display device (DD2) are spaced apart from each other by a second emission separation distance (340),
the first adjacent emission area (3200) is an area closest to the second display device (DD2), among the first emission area (EMA1), the second emission area (EMA2), and the third emission area (EMA3) disposed in the first display device (DD1),
the second adjacent emission area (3400) is an area closest to the first display device (DD1), among the first emission area (EMA1), the second emission area (EMA2), and the third emission area (EMA3) disposed in the second display device (DD2), and
the first emission separation distance (320) is different from the second emission separation distance (340).

16. The tiled display device according to claim 15, wherein the second emission separation distance (340) is greater than the second separation distance (240).

## Patentansprüche

1. Gekachelte Anzeigevorrichtung (TDD), umfassend:
ein erstes Panel (PNL1) einschließlich einer ersten Anzeigeelementschicht (DPL1);
ein zweites Panel (PNL2) einschließlich einer zweiten Anzeigeelementschicht (DPL2);
eine gemeinsame Schicht (100) einschließlich eines Farbkonvertierungsteils (CCL);
wobei die gemeinsame Schicht (100) einen ersten Abschnitt und einen zweiten Abschnitt einschließt;
wobei der erste Abschnitt in einer Draufsicht mit dem ersten Panel (PNL1) überlappt,
wobei der zweite Abschnitt in einer Draufsicht mit dem zweiten Panel (PNL2) überlappt und
wobei das Farbkonvertierungsteil (CCL) so konfiguriert ist, dass es eine Wellenlänge des von dem ersten Panel (PNL1) und dem zweiten Panel (PNL2) gelieferten Lichts ändert, wobei
das Farbumwandlungsteil (CCL) umfasst:
ein erstes Farbteil (1200), das Licht einer ersten Farbe liefert;
ein zweites Farbteil (1400), das Licht einer zweiten Farbe liefert; und
ein drittes Farbteil (1600), das Licht einer dritten Farbe liefert, und
das erste Farbteil (1200), das zweite Farbteil (1400) und das dritte Farbteil (1600) in einer Draufsicht das erste Panel (PNL1) und das zweite Panel (PNL2) überlappen;
einen ersten Subpixelbereich (SPXA1), der das Licht der ersten Farbe ausstrahlt und in einer Draufsicht das erste Farbteil (1200) überlappt;
einen zweiten Subpixelbereich (SPXA2), der das Licht der zweiten Farbe ausstrahlt und das zweite Farbteil (1400) in einer Draufsicht überlappt; und
einen dritten Subpixelbereich (SPXA3), der das Licht der dritten Farbe ausstrahlt und in einer Draufsicht das dritte Farbteil (1600) überlappt,
wobei die erste Anzeigeelementschicht (DPL1) ein erstes Leuchtelement und die zweite Anzeigeelementschicht (DPL2) ein zweites Leuchtelement einschließt, wobei die gekachelte Anzeigevorrichtung (TDD) weiter Folgendes umfasst:
einen Emissionsbereich (EMA), in dem das erste Leuchtelement und das zweite Leuchtelement angeordnet sind,
wobei der Emissionsbereich (EMA) durch Komponenten definiert wird, die in der ersten Anzeigeelementschicht (DPL1) und der zweiten Anzeigeelementschicht (DPL2) einschließt sind, optional wobei
jede der ersten Anzeigeelementschicht (DPL1) und der zweiten Anzeigeelementschicht (DPL2) eine Bank (BNK) einschließt, die in einer Anzeigerichtung der gekachelten Anzeigevorrichtung (TDD) herausragt, und
die Bank (BNNK) eine Form aufweist, die den Emissionsbereich (EMA) umschließt, wobei der Emissionsbereich (EMA) Folgendes umfasst:
einen ersten Emissionsbereich (EMA1), der in einer Draufsicht den ersten Subpixelbereich (SPXA1) überlappt;
einen zweiten Emissionsbereich (EMA2), der in einer Draufsicht den zweiten Subpixelbereich (SPXA2) überlappt; und
einen dritten Emissionsbereich (EMA3), der in einer Draufsicht den dritten Subpixelbereich (SPXA3) überlappt, und
**dadurch gekennzeichnet, dass**
das erste Farbteil (1200) in einer Draufsicht so angeordnet ist, dass es gegenüber dem ersten Emissionsbereich (EMA1) fehlausgerichtet ist,
das zweite Farbteil (1400) in einer Draufsicht so angeordnet ist, dass es gegenüber dem zweiten Emissionsbereich (EMA2) fehlausgerichtet ist, und
das dritte Farbteil (1600) in einer Draufsicht so angeordnet ist, dass es gegenüber dem dritten Emissionsbereich (EMA3) fehlausgerichtet ist.

2. Gekachelte Anzeigevorrichtung (TDD) nach Anspruch 1, wobei das erste Panel (PNL1) und das zweite Panel (PNL2) ein unteres Panel der gekachelten Anzeigevorrichtung (TDD) bilden und die gemeinsame Schicht (100) ein oberes Panel der gekachelten Anzeigevorrichtung (TDD) bildet.

3. Gekachelte Anzeigevorrichtung (TDD) nach Anspruch 1 oder 2, wobei
das erste Panel (PNL1) und das zweite Panel (PNL2) auf einer selben Schicht angeordnet sind,
das erste Panel (PNL1) und das zweite Panel (PNL2) voneinander beabstandet sind und
zwischen dem ersten Panel (PNL1) und dem zweiten Panel (PNL2) ein Bindungsbereich (BA) angeordnet ist.

4. Gekachelte Anzeigevorrichtung (TDD) nach Anspruch 3, wobei der Bindungsbereich (BA) in einer Draufsicht die gemeinsame Schicht (100) überlappt.

5. Gekachelte Anzeigevorrichtung (TDD) nach einem vorstehenden Anspruch, wobei die gemeinsame Schicht (100) weiter Folgendes umfasst:
ein erstes Farbfilter (CF1), das den ersten Subpixelbereich (SPXA1) in einer Draufsicht überlappt;
ein zweites Farbfilter (CF2), das den zweiten Subpixelbereich (SPXA2) in einer Draufsicht überlappt; und
ein drittes Farbfilter (CF3), das den dritten Subpixelbereich (SPXA3) in einer Draufsicht überlappt.

6. Gekachelte Anzeigevorrichtung nach Anspruch 5, wobei jede der ersten Anzeigeelementschicht (DPL1) und der zweiten Anzeigeelementschicht (DPL2) eine in einer Anzeigerichtung der gekachelten Anzeigevorrichtung (TDD) herausragende Bank (BNK) einschließt und
die Bank (BNK) eine Form aufweist, die den Emissionsbereich (EMA) umschließt.

7. Gekachelte Anzeigevorrichtung (TDD) nach einem vorstehenden Anspruch, wobei:
mindestens ein Teil des ersten Farbteils (1200) in einer Draufsicht den ersten Emissionsbereich (EMA1) überlappt und
der andere Teil des ersten Farbteils (1200) in einer Draufsicht den ersten Emissionsbereich (EMA1) nicht überlappt.

8. Gekachelte Anzeigevorrichtung (TDD) nach einem vorstehenden Anspruch, wobei:
das erste Panel (PNL1) und der erste Abschnitt der gemeinsamen Schicht (100) eine erste Anzeigevorrichtung (DD1) bilden,
das zweite Panel (PNL1) und der zweite Abschnitt der gemeinsamen Schicht (100) eine zweite Anzeigevorrichtung (DD2) bilden,
in der ersten Anzeigevorrichtung (DD1) und in der zweiten Anzeigevorrichtung (DD2) der erste Subpixelbereich (SPXA1) der zweite Subpixelbereich (SPXA2) und der dritte Subpixelbereich (SPXA3) aneinander angrenzen und durch einen ersten Trennabstand (220) voneinander beabstandet sind,
ein erster angrenzender Subpixelbereich (2200) der ersten Anzeigevorrichtung (DD1) und ein zweiter angrenzender Subpixelbereich (2400) der zweiten Anzeigevorrichtung (DD2) durch einen zweiten Trennabstand (240) voneinander beabstandet sind,
der erste angrenzende Subpixelbereich (2200) ein Bereich von dem ersten Subpixelbereich (SPXA1), dem zweiten Subpixelbereich (SPXA2) und dem dritten Subpixelbereich (SPXA3), die in der ersten Anzeigevorrichtung (DD1) angeordnet sind, ist, der der zweiten Anzeigevorrichtung (DD2) am nächsten liegt,
der zweite angrenzende Subpixelbereich (2400) ein Bereich von dem ersten Subpixelbereich (SPXA1), dem zweiten Subpixelbereich (SPXA2) und dem dritten Subpixelbereich (SPXA3), die in der zweiten Anzeigevorrichtung (DD2) angeordnet sind, ist, der der ersten Anzeigevorrichtung (DD1) am nächsten liegt, und
der erste Trennabstand (220) gleich dem zweiten Trennabstand (240) ist,
optional eine Farbe, die vom ersten angrenzenden Subpixelbereich (2200) geliefert wird, und eine Farbe, die vom zweiten angrenzenden Subpixelbereich (2400) geliefert wird, unterschiedlich sind.

9. Gekachelte Anzeigevorrichtung nach Anspruch 8, wobei
in der ersten Anzeigevorrichtung (DD1) und in der zweiten Anzeigevorrichtung (DD2) der erste Emissionsbereich (EMA1), der zweite Emissionsbereich (EMA2) und der dritte Emissionsbereich (EMA3) aneinander angrenzen und durch einen ersten Emissionstrennabstand (320) voneinander beabstandet sind,
ein erster angrenzender Emissionsbereich (3200) der ersten Anzeigevorrichtung (DD1) und ein zweiter angrenzender Emissionsbereich (3400) der zweiten Anzeigevorrichtung (DD2) durch einen zweiten Emissionstrennabstand (340) voneinander beabstandet sind,
der erste angrenzende Emissionsbereich (3200) ein Bereich von dem erstem Emissionsbereich (EMA1), dem zweiten Emissionsbereich (EMA2) und dem dritten Emissionsbereich (EMA3), die in der ersten Anzeigevorrichtung (DD1) angeordnet sind, ist, der der zweiten Anzeigevorrichtung (DD2) am nächsten liegt,
der zweite angrenzende Emissionsbereich (3400) ein Bereich von dem erstem Emissionsbereich (EMA1), dem zweiten Emissionsbereich (EMA2) und dem dritten Emissionsbereich (EMA3), die in der zweiten Anzeigevorrichtung (DD2) angeordnet sind, ist, der der ersten Anzeigevorrichtung (DD1) am nächsten liegt, und
der erste Emissionstrennabstand (320) sich vom zweiten Emissionstrennabstand (340) unterscheidet, wobei optional der zweite Emissionstrennabstand (340) größer ist als der zweite Trennabstand (240).

10. Gekachelte Anzeigevorrichtung nach Anspruch 9, wobei, von außen betrachtet,
das Licht der ersten Farbe im ersten Subpixelbereich (SPXA1) beobachtet wird,
das Licht der zweiten Farbe im zweiten Subpixelbereich (SPXA2) beobachtet wird und
das Licht der dritten Farbe im dritten Subpixelbereich (SPXA3) beobachtet wird.

11. Gekachelte Anzeigevorrichtung nach Anspruch 9 oder 10, wobei
das erste Panel (PNL1) und das zweite Panel (PNL2) auf einer selben Schicht angeordnet sind,
das erste Panel (PNL1) und das zweite Panel (PNL2) voneinander beabstandet sind,
zwischen dem ersten Panel (PNL1) und dem zweiten Panel (PNL2) ein Bindungsbereich (BA) angeordnet ist und
die Dicke des Bindungsbereichs (BA) kleiner ist als der zweite Trennungsabstand (240).

12. Gekachelte Anzeigevorrichtung nach einem vorstehenden Anspruch, wobei:
das erste Farbteil (1200) einen ersten Quantenpunkt umfasst, der das Licht der dritten Farbe in das Licht der ersten Farbe umwandelt, und
das zweite Farbteil (1400) einen zweiten Quantenpunkt umfasst, der das Licht der dritten Farbe in das Licht der zweiten Farbe umwandelt.

13. Gekachelte Anzeigevorrichtung nach Anspruch 12, wobei die erste Anzeigeelementschicht (DPL1) ein erstes Leuchtelement einschließt und die zweite Anzeigeelementschicht (DPL2) ein zweites Leuchtelement einschließt und
wobei jedes des ersten Leuchtelements und des zweiten Leuchtelements Licht der dritten Farbe ausstrahlt.

14. Gekachelte Anzeigevorrichtung (TDD) nach einem vorstehenden Anspruch, wobei die erste Anzeigeelementschicht (DPL1) ein erstes Leuchtelement einschließt und die zweite Anzeigeelementschicht (DPL2) ein zweites Leuchtelement einschließt und
wobei es sich bei dem ersten Leuchtelement und dem zweiten Leuchtelement um eine organische Leuchtdiode oder eine Leuchtdiode, die eine Größe im Nanometerbereich bis Mikrometerbereich aufweist, handelt.

15. Gekachelte Anzeigevorrichtung (TDD), umfassend:
ein erstes Panel (PNL1) einschließlich einer ersten Anzeigeelementschicht (DPL1);
ein zweites Panel (PNL2) einschließlich einer zweiten Anzeigeelementschicht (DPL2);
eine gemeinsame Schicht (100) einschließlich eines Farbkonvertierungsteils (CCL);
wobei die gemeinsame Schicht (100) einen ersten Abschnitt und einen zweiten Abschnitt einschließt;
wobei der erste Abschnitt in einer Draufsicht mit dem ersten Panel (PNL1) überlappt,
wobei der zweite Abschnitt in einer Draufsicht mit dem zweiten Panel (PNL2) überlappt und
wobei das Farbkonvertierungsteil (CCL) so konfiguriert ist, dass es eine Wellenlänge des von dem ersten Panel (PNL1) und dem zweiten Panel (PNL2) gelieferten Lichts ändert, wobei
das Farbumwandlungsteil (CCL) umfasst:
ein erstes Farbteil (1200), das Licht einer ersten Farbe liefert;
ein zweites Farbteil (1400), das Licht einer zweiten Farbe liefert; und
ein drittes Farbteil (1600), das Licht einer dritten Farbe liefert, und
das erste Farbteil (1200), das zweite Farbteil (1400) und das dritte Farbteil (1600) in einer Draufsicht das erste Panel (PNL1) und das zweite Panel (PNL2) überlappen,
einen ersten Subpixelbereich (SPXA1), der das Licht der ersten Farbe ausstrahlt und in einer Draufsicht das erste Farbteil (1200) überlappt;
einen zweiten Subpixelbereich (SPXA2), der das Licht der zweiten Farbe ausstrahlt und das zweite Farbteil (1400) in einer Draufsicht überlappt; und
einen dritten Subpixelbereich (SPXA3), der das Licht der dritten Farbe ausstrahlt und in einer Draufsicht das dritte Farbteil (1600) überlappt,
wobei die erste Anzeigeelementschicht (DPL) ein erstes Leuchtelement und die zweite Anzeigeelementschicht (DPL2) ein zweites Leuchtelement einschließt, wobei die gekachelte Anzeigevorrichtung (TDD) weiter Folgendes umfasst:
einen Emissionsbereich (EMA), in dem das erste Leuchtelement und das zweite Leuchtelement angeordnet sind,
wobei der Emissionsbereich (EMA) durch Komponenten definiert wird, die in der ersten Anzeigeelementschicht (DPL1) und der zweiten Anzeigeelementschicht (DPL2) einschließt sind, optional wobei
jede der ersten Anzeigeelementschicht (DPL1) und der zweiten Anzeigeelementschicht (DPL2) eine Bank (BNK) einschließt, die in einer Anzeigerichtung der gekachelten Anzeigevorrichtung (TDD) herausragt, und
die Bank (BHK) eine Form aufweist, die den Emissionsbereich (EMA) umschließt,
wobei der Emissionsbereich (EMA) Folgendes umfasst:
einen ersten Emissionsbereich (EMA1), der in einer Draufsicht den ersten Subpixelbereich (SPXA1) überlappt;
einen zweiten Emissionsbereich (EMA2), der in einer Draufsicht den zweiten Subpixelbereich (SPXA2) überlappt; und
einen dritten Emissionsbereich (EMA3), der in einer Draufsicht den dritten Subpixelbereich (SPXA3) überlappt,
wobei
das erste Panel (PNL1) und der erste Abschnitt der gemeinsamen Schicht (100) eine erste Anzeigevorrichtung (DD1) bilden,
das zweite Panel (PNL2) und der zweite Abschnitt der gemeinsamen Schicht (100) eine zweite Anzeigevorrichtung (DD2) bilden,
in der ersten Anzeigevorrichtung (DD1) und in der zweiten Anzeigevorrichtung (DD2) der erste Subpixelbereich (SPXA1) der zweite Subpixelbereich (SPXA2) und der dritte Subpixelbereich (SPXA3) aneinander angrenzen und durch einen ersten Trennabstand (220) voneinander beabstandet sind,
ein erster angrenzender Subpixelbereich (2200) der ersten Anzeigevorrichtung (DD1) und ein zweiter angrenzender Subpixelbereich (2400) der zweiten Anzeigevorrichtung (DD2) durch einen zweiten Trennabstand (240) voneinander beabstandet sind,
der erste angrenzende Subpixelbereich (2200) ein Bereich von dem ersten Subpixelbereich (SPXA1), dem zweiten Subpixelbereich (SPXA2) und dem dritten Subpixelbereich (SPXA3), die in der ersten Anzeigevorrichtung (DD1) angeordnet sind, ist, der der zweiten Anzeigevorrichtung (DD2) am nächsten liegt,
der zweite angrenzende Subpixelbereich (2400) ein Bereich von dem ersten Subpixelbereich (SPXA1), dem zweiten Subpixelbereich (SPXA2) und dem dritten Subpixelbereich (SPXA3), die in der zweiten Anzeigevorrichtung (DD2) angeordnet sind, ist, der der ersten Anzeigevorrichtung (DD1) am nächsten liegt, und
der erste Trennabstand (220) gleich dem zweiten Trennabstand (240) ist,
optional eine Farbe, die vom ersten angrenzenden Subpixelbereich (2200) geliefert wird, und eine Farbe, die vom zweiten angrenzenden Subpixelbereich (2400) geliefert wird, unterschiedlich sind und
wobei
in der ersten Anzeigevorrichtung (DD1) und in der zweiten Anzeigevorrichtung (DD2) der erste Emissionsbereich (EMA1), der zweite Emissionsbereich (EMA2) und der dritte Emissionsbereich (EMA3) aneinander angrenzen und durch einen ersten Emissionstrennabstand (320) voneinander beabstandet sind,
ein erster angrenzender Emissionsbereich (320) der ersten Anzeigevorrichtung (DD1) und ein zweiter angrenzender Emissionsbereich (3400) der zweiten Anzeigevorrichtung (DD2) durch einen zweiten Emissionstrennabstand (340) voneinander beabstandet sind,
der erste angrenzende Emissionsbereich (3200) ein Bereich von dem erstem Emissionsbereich (EMA1), dem zweiten Emissionsbereich (EMA2) und dem dritten Emissionsbereich (EMA3), die in der ersten Anzeigevorrichtung (DD1) angeordnet sind, ist, der der zweiten Anzeigevorrichtung (DD2) am nächsten liegt,
der zweite angrenzende Emissionsbereich (3400) ein Bereich von dem erstem Emissionsbereich (EMA1), dem zweiten Emissionsbereich (EMA2) und dem dritten Emissionsbereich (EMA3), die in der zweiten Anzeigevorrichtung (DD2) angeordnet sind, ist, der der ersten Anzeigevorrichtung (DD1) am nächsten liegt, und
der erste Emissionstrennabstand (320) sich vom zweiten Emissionstrennabstand (340) unterscheidet.

16. Gekachelte Anzeigevorrichtung nach Anspruch 15, wobei der zweite Emissionstrennabstand (340) größer ist als der zweite Trennabstand (240).

## Revendications

1. Dispositif d'affichage en mosaïque (TDD) comprenant :
un premier panneau (PNL1) incluant une première couche d'éléments d'affichage (DPL1) ;
un second panneau (PNL2) incluant une seconde couche d'éléments d'affichage (DPL2) ;
une couche partagée (100) incluant une partie de conversion de couleur (CCL) ;
dans lequel la couche partagée (100) inclut une première partie et une deuxième partie ;
dans lequel la première partie chevauche le premier panneau (PNL1) dans une vue en plan,
dans lequel la deuxième partie chevauche le second panneau (PNL2) dans une vue en plan, et
dans lequel la partie de conversion de couleur (CCL) est configurée pour modifier une longueur d'onde de lumière provenant du premier panneau (PNL1) et du second panneau (PNL2), dans lequel
la partie conversion de couleur (CCL) comprend :
une première partie de couleur (1200) fournissant de la lumière d'une première couleur ;
une deuxième partie de couleur (1400) fournissant de la lumière d'une deuxième couleur ; et
une troisième partie de couleur (1600) fournissant de la lumière d'une troisième couleur, et
la première partie de couleur (1200), la deuxième partie de couleur (1400) et la troisième partie de couleur (1600) chevauchent le premier panneau (PNL1) et le deuxième panneau (PNL2) dans une vue en plan ;
une première zone de sous-pixel (SPXA1) émettant la lumière de la première couleur et chevauchant la première partie de couleur (1200) dans une vue en plan ;
une deuxième zone de sous-pixel (SPXA2) émettant la lumière de la deuxième couleur et chevauchant la deuxième partie de couleur (1400) dans une vue en plan ; et
une troisième zone de sous-pixel (SPXA3) émettant la lumière de la troisième couleur et chevauchant la troisième partie de couleur (1600) dans une vue en plan,
dans lequel la première couche d'éléments d'affichage (DPL1) inclut un premier élément électroluminescent, et la seconde couche d'éléments d'affichage (DPL2) inclut un second élément électroluminescent, dans lequel le dispositif d'affichage modulaire (TDD) comprend en outre :
une zone d'émission (EMA) dans laquelle sont disposés le premier élément électroluminescent et le second élément électroluminescent,
dans lequel la zone d'émission (EMA) est définie par des composants inclus dans la première couche d'éléments d'affichage (DPL1) et la seconde couche d'éléments d'affichage (DPL2), éventuellement dans lequel
chacune de la première couche d'éléments d'affichage (DPL1) et de la seconde couche d'affichage (DPL2) inclut un banc (BNK) faisant saillie dans la direction d'affichage du dispositif d'affichage en mosaïque (TDD), et
le banc (BNNK) présente une forme englobant la zone d'émission (EMA), dans lequel la zone d'émission (EMA) comprend :
une première zone d'émission (EMA1) chevauchant la première zone de sous-pixel (SPXA1) dans une vue en plan ;
une deuxième zone d'émission (EMA2) chevauchant la deuxième zone de sous-pixel (SPXA2) dans une vue en plan ; et
une troisième zone d'émission (EMA3) chevauchant une troisième zone de sous-pixel (SPXA3) dans une vue en plan, et
**caractérisé en ce que**
la première partie de couleur (1200) est disposée de façon à être désalignée par rapport à la première zone d'émission (EMA1) dans une vue en plan,
la deuxième partie de couleur (1400) est disposée de façon à être désalignée par rapport à la deuxième zone d'émission (EMA2) dans une vue en plan, et
la troisième partie de couleur (1600) est disposée de façon à être désalignée par rapport à la troisième zone d'émission (EMA3) dans une vue en plan.

2. Dispositif d'affichage en mosaïque (TDD) selon la revendication 1, dans lequel le premier panneau (PNL1) et le second panneau (PNL2) forment un panneau inférieur du dispositif d'affichage en mosaïque (TDD), et la couche partagée (100) forme un panneau supérieur du dispositif d'affichage en mosaïque (TDD).

3. Dispositif d'affichage en mosaïque (TDD) selon la revendication 1 ou 2, dans lequel
le premier panneau (PNL1) et le second panneau (PNL2) sont disposés sur une même couche,
le premier panneau (PNL1) et le second panneau (PNL2) sont espacés l'un de l'autre, et
une zone de liaison (BA) est disposée entre le premier panneau (PNL1) et le second panneau (PNL2).

4. Dispositif d'affichage en mosaïque (TDD) selon la revendication 3, dans lequel la zone de liaison (BA) chevauche la couche partagée (100) dans une vue en plan.

5. Dispositif d'affichage en mosaïque (TDD) selon l'une quelconque des revendications précédentes, dans lequel la couche partagée (100) comprend en outre :
un premier filtre de couleur (CF1) chevauchant la première zone de sous-pixel (SPXA1) dans une vue en plan ;
un deuxième filtre de couleur (CF2) chevauchant la deuxième zone de sous-pixel (SPXA2) dans une vue en plan ; et
un troisième filtre de couleur (CF3) chevauchant la troisième zone de sous-pixel (SPXA3) dans une vue en plan.

6. Dispositif d'affichage en mosaïque selon la revendication 5, chacune de la première couche d'élément d'affichage (DPL1) et de la deuxième couche d'élément d'affichage (DPL2) inclut un banc (BNK) faisant saillie dans la direction d'affichage du dispositif d'affichage en mosaïque (TDD), et
le banc (BNK) présente une forme englobant la zone d'émission (EMA).

7. Dispositif d'affichage en mosaïque (TDD) selon une quelconque revendication précédente, dans lequel
au moins une partie de la première zone de couleur (1200) chevauche la première zone d'émission (EMA1) dans une vue en plan, et
l'autre partie de la première partie de couleur (1200) ne chevauche pas la première zone d'émission (EMA1) dans une vue en plan.

8. Dispositif d'affichage en mosaïque (TDD) selon une quelconque revendication précédente, dans lequel
le premier panneau (PNL1) et la première partie de la couche partagée (100) forment un premier dispositif d'affichage (DD1),
le second panneau (PNL1) et la deuxième partie de l'écran partagé (100) forment un second dispositif d'affichage (DD2),
dans le premier dispositif d'affichage (DD1) et le second dispositif d'affichage (DD2), la première zone de sous-pixel (SPXA1), la deuxième zone de sous-pixel (SPXA2) et la troisième zone de sous-pixel (SPXA3) sont adjacentes les unes aux autres et sont espacées les unes des autres par une première distance de séparation (220),
une première zone de sous-pixel adjacente (2200) du premier dispositif d'affichage (DD1) et une deuxième zone de sous-pixel adjacente (2400) du second dispositif d'affichage (DD2) sont espacées l'une de l'autre par une seconde distance de séparation (240),
la première zone de sous-pixel adjacente (2200) est une zone la plus proche du second dispositif d'affichage (DD2), parmi la première zone de sous-pixel (SPXA1), la deuxième zone de sous-pixel (SPXA2) et la troisième zone de sous-pixel (SPXA3) disposées dans le premier dispositif d'affichage (DD1),
la deuxième zone de sous-pixel adjacente (2400) est une zone la plus proche du premier dispositif d'affichage (DD1), parmi la première zone de sous-pixel (SPXA1), la deuxième zone de sous-pixel (SPXA2) et la troisième zone de sous-pixel (SPXA3) disposées dans le second dispositif d'affichage (DD2), et
la première distance de séparation (220) est égale à la seconde distance de séparation (240),
éventuellement, une couleur fournie par la première zone de sous-pixel adjacente (2200) et une couleur fournie par la deuxième zone de sous-pixel adjacente (2400) sont différentes l'une de l'autre.

9. Dispositif d'affichage en mosaïque selon la revendication 8, dans lequel
dans le premier dispositif d'affichage (DD1) et le second dispositif d'affichage (DD2), la première zone d'émission (EMA1), la deuxième zone d'émission (EMA2) et la troisième zone d'émission (EMA3) sont adjacentes les unes aux autres et sont espacées les unes des autres par une première distance de séparation d'émission (320),
une première zone d'émission adjacente (3200) du premier dispositif d'affichage (DD1) et une deuxième zone d'émission adjacente (3400) du second dispositif d'affichage (DD2) sont espacées l'une de l'autre par une seconde distance de séparation d'émission (340),
la première zone d'émission adjacente (3200) est une zone la plus proche du second dispositif d'affichage (DD2), parmi la première zone d'émission (EMA1), la deuxième zone d'émission (EMA2) et la troisième zone d'émission (EMA3) disposées dans le premier dispositif d'affichage (DD1),
la deuxième zone d'émission adjacente (3400) est une zone la plus proche du premier dispositif d'affichage (DD1), parmi la première zone d'émission (EMA1), la deuxième zone d'émission (EMA2) et la troisième zone d'émission (EMA3) disposées dans le second dispositif d'affichage (DD2), et
la première distance de séparation d'émission (320) est différente de la seconde distance de séparation d'émission (340), éventuellement la seconde distance de séparation d'émission (340) est supérieure à la seconde distance de séparation (240).

10. Dispositif d'affichage en mosaïque selon la revendication 9, dans lequel, vu de l'extérieur,
la lumière de la première couleur est observée dans la première zone de sous-pixel (SPXA1),
la lumière de la deuxième couleur est observée dans la deuxième zone de sous-pixel (SPXA2), et
la lumière de la troisième couleur est observée dans la troisième zone de sous-pixel (SPXA3).

11. Dispositif d'affichage en mosaïque selon la revendication 9 ou 10, dans lequel
le premier panneau (PNL1) et le second panneau (PNL2) sont disposés sur une même couche,
le premier panneau (PNL1) et le second panneau (PNL2) sont espacés l'un de l'autre,
une zone de liaison (BA) est disposée entre le premier panneau (PNL1) et le second panneau (PNL2), et
l'épaisseur de la zone de liaison (BA) est inférieure à la seconde distance de séparation (240).

12. Dispositif d'affichage en mosaïque selon une quelconque revendication précédente, dans lequel :
la première partie colorée (1200) comprend un premier point quantique convertissant la lumière de la troisième couleur en lumière de la première couleur, et
la deuxième partie de couleur (1400) comprend un second point quantique convertissant la lumière de la troisième couleur en lumière de la deuxième couleur.

13. Dispositif d'affichage en mosaïque selon la revendication 12, dans lequel la première couche d'éléments d'affichage (DPL1) inclut un premier élément électroluminescent, et la seconde couche d'éléments d'affichage (DPL2) inclut un second élément électroluminescent, et
dans lequel chacun du premier et du second élément électroluminescent émet la lumière de la troisième couleur.

14. Dispositif d'affichage en mosaïque (TDD) selon une quelconque revendication précédente, dans lequel la première couche d'éléments d'affichage (DPL1) inclut un premier élément électroluminescent, et la seconde couche d'éléments d'affichage (DPL2) inclut un second élément électroluminescent, et
dans lequel le premier élément électroluminescent et le second élément électroluminescent sont une diode électroluminescente organique ou une diode électroluminescente présentant une taille comprise entre l'échelle nanométrique et l'échelle micrométrique.

15. Dispositif d'affichage en mosaïque (TDD) comprenant :
un premier panneau (PNL1) incluant une première couche d'éléments d'affichage (DPL1) ;
un second panneau (PNL2) incluant une seconde couche d'éléments d'affichage (DPL2) ;
une couche partagée (100) incluant une partie de conversion de couleur (CCL) ;
dans lequel la couche partagée (100) inclut une première partie et une seconde partie ;
dans lequel la première partie chevauche le premier panneau (PNL1) dans une vue en plan,
dans lequel la seconde partie chevauche le deuxième panneau (PNL2) dans une vue en plan, et
dans lequel la partie de conversion de couleur (CCL) est configurée pour modifier une longueur d'onde de lumière provenant du premier panneau (PNL1) et du second panneau (PNL2), dans lequel
la partie conversion de couleur (CCL) comprend :
une première partie de couleur (1200) fournissant de la lumière d'une première couleur ;
une deuxième partie de couleur (1400) fournissant de la lumière d'une deuxième couleur ; et
une troisième partie de couleur (1600) fournissant de la lumière d'une troisième couleur, et
la première partie de couleur (1200), la deuxième partie de couleur (1400) et la troisième partie de couleur (1600) chevauchent le premier panneau (PNL1) et le second panneau (PNL2) dans une vue en plan,
une première zone de sous-pixel (SPXA1) émettant la lumière de la première couleur et chevauchant la première partie de couleur (1200) dans une vue en plan ;
une deuxième zone de sous-pixel (SPXA2) émettant la lumière de la deuxième couleur et chevauchant la deuxième partie de couleur (1400) dans une vue en plan ; et
une troisième zone de sous-pixel (SPXA3) émettant la lumière de la troisième couleur et chevauchant la troisième partie de couleur (1600) dans une vue en plan,
dans lequel la première couche d'éléments d'affichage (DPL) inclut un premier élément électroluminescent, et la seconde couche d'éléments d'affichage (DPL2) inclut un second élément électroluminescent, dans lequel le dispositif d'affichage en mosaïque (TDD) comprend en outre :
une zone d'émission (EMA) dans laquelle sont disposés le premier élément électroluminescent et le second élément électroluminescent,
dans lequel la zone d'émission (EMA) est définie par des composants inclus dans la première couche d'éléments d'affichage (DPL1) et la seconde couche d'éléments d'affichage (DPL2), éventuellement dans lequel
chacune de la première couche d'éléments d'affichage (DPL1) et de la seconde couche d'affichage (DPL2) inclut un banc (BNK) faisant saillie dans la direction d'affichage du dispositif d'affichage en mosaïque (TDD), et
le banc (BHK) présente une forme qui englobe la zone d'émission (EMA),
dans lequel la zone d'émission (EMA) comprend :
une première zone d'émission (EMA1) chevauchant la première zone de sous-pixel (SPXA1) dans une vue en plan ;
une deuxième zone d'émission (EMA2) chevauchant la deuxième zone de sous-pixel (SPXA2) dans une vue en plan ; et
une troisième zone d'émission (EMA3) chevauchant une troisième zone de sous-pixel (SPXA3) dans une vue en plan,
dans lequel
le premier panneau (PNL1) et la première partie de la couche partagée (100) forment un premier dispositif d'affichage (DD1),
le second panneau (PNL2) et la seconde partie de la couche partagée (100) forment un second dispositif d'affichage (DD2),
dans le premier dispositif d'affichage (DD1) et le second dispositif d'affichage (DD2), la première zone de sous-pixel (SPXA1), la deuxième zone de sous-pixel (SPXA2) et la troisième zone de sous-pixel (SPXA3) sont adjacentes les unes aux autres et sont espacées les unes des autres par une première distance de séparation (220),
une première zone de sous-pixel adjacente (2200) du premier dispositif d'affichage (DD1) et une deuxième zone de sous-pixel adjacente (2400) du second dispositif d'affichage (DD2) sont espacées l'une de l'autre par une seconde distance de séparation (240),
la première zone de sous-pixel adjacente (2200) est une zone la plus proche du second dispositif d'affichage (DD2), parmi la première zone de sous-pixel (SPXA1), la deuxième zone de sous-pixel (SPXA2) et la troisième zone de sous-pixel (SPXA3) disposées dans le premier dispositif d'affichage (DD1),
la deuxième zone de sous-pixel adjacente (2400) est une zone la plus proche du premier dispositif d'affichage (DD1), parmi la première zone de sous-pixel (SPXA1), la deuxième zone de sous-pixel (SPXA2) et la troisième zone de sous-pixel (SPXA3) disposées dans le second dispositif d'affichage (DD2), et
la première distance de séparation (220) est égale à la seconde distance de séparation (240),
éventuellement, une couleur fournie par la première zone de sous-pixel adjacente (2200) et une couleur fournie par la deuxième zone de sous-pixel adjacente (2400) sont différentes l'une de l'autre, et
dans lequel,
dans le premier dispositif d'affichage (DD1) et le second dispositif d'affichage (DD2), la première zone d'émission (EMA1), la deuxième zone d'émission (EMA2) et la troisième zone d'émission (EMA3) sont adjacentes les unes aux autres et sont espacées les unes des autres par une première distance de séparation d'émission (320),
une première zone d'émission adjacente (320) du premier dispositif d'affichage (DD1) et une deuxième zone d'émission adjacente (3400) du second dispositif d'affichage (DD2) sont espacées l'une de l'autre par une seconde distance de séparation d'émission (340),
la première zone d'émission adjacente (3200) est une zone la plus proche du second dispositif d'affichage (DD2), parmi la première zone d'émission (EMA1), la deuxième zone d'émission (EMA2) et la troisième zone d'émission (EMA3) disposées dans le premier dispositif d'affichage (DD1),
la deuxième zone d'émission adjacente (3400) est une zone la plus proche du premier dispositif d'affichage (DD1), parmi la première zone d'émission (EMA1), la deuxième zone d'émission (EMA2) et la troisième zone d'émission (EMA3) disposées dans le second dispositif d'affichage (DD2), et
la première distance de séparation d'émission (320) est différente de la seconde distance de séparation d'émission (340).

16. Dispositif d'affichage en mosaïque selon la revendication 15, dans lequel la seconde distance de séparation d'émission (340) est supérieure à la seconde distance de séparation (240).
